(19) Europäisches Patentamt / European Patent Office / Office européen des brevets

(11) **EP 2 746 797 B1**

(12) **EUROPEAN PATENT SPECIFICATION**

(45) Date of publication and mention
of the grant of the patent:
**04.09.2019  Bulletin 2019/36**

(51) Int Cl.:
***G01R 31/385*** (2019.01)   ***G01R 31/367*** (2019.01)

(21) Application number: **13425155.2**

(22) Date of filing: **09.12.2013**

(54) **Method for the characterisation of accumulators**

Verfahren zur Charakterisierung von Akkumulatoren

Procédé pour la caractérisation d'accumulateurs

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.12.2012  IT RM20120643**

(43) Date of publication of application:
**25.06.2014  Bulletin 2014/26**

(73) Proprietor: **Calbatt S.r.l.
87036 Rende (CS) (IT)**

(72) Inventors:
• **Amoroso, Francesco Antonio
87036 Rende (CS) (IT)**
• **Cappuccino, Gregorio
87036 Rende CS (IT)**

(74) Representative: **Perronace, Andrea et al
Jacobacci & Partners S.p.A.
Via Tomacelli, 146
00186 Roma (IT)**

(56) References cited:
**EP-A1- 2 375 487   EP-A2- 1 065 772
WO-A1-00/31557**

## Description

The present invention concerns the characterisation of accumulators.

## Framework of the invention and state of the art

The energy accumulation systems based on batteries are being more and more utilised in a series of applications, such as for example the storage of energy coming from intermittent renewable sources and the propulsion of electric-driven vehicles.

In these applications, it is fundamental to perform the accumulators charging process in an optimal way, monitoring continuously some performances such as the state of charge (SOC) and the state of health (SOH) of the accumulator, and above all the energetic efficiency of the charging process, which is understood as the ratio between the energy actually stored by the accumulator and the energy overall supplied to the same during the charging process.

In this concern, it is appropriate to stress that, notwithstanding that the meanings of the two quantities are often confused, there is a substantial difference between the just described energetic efficiency and the coulombic efficiency, which is understood instead as the ratio between the charge actually stored into the accumulator and the one supplied altogether to the same accumulator during the charging process. Indeed, whilst the energetic efficiency is affected by all the causes of energy dissipation within a charging process, the coulombic efficiency is calculated by taking into account only the losses due to the secondary chemical reactions, that are those transforming the absorbed electric charge into electric charge accumulated at the terminals of the accumulator and available for a subsequent discharge process of the same accumulator (Berman et al., patent US4001036A, Horn et al. brevetto 4,952,861, Ceraolo, "New Dynamical Models of Lead-Acid Batteries"), and that activate themselves during the charging processes of some types of accumulators (for example Lead, NiMH, NiCd) when the current supplied to the accumulator exceeds the maximum speed with which the primary chemical reactions can transform the supplied current into electric charge accumulated at the terminals of the accumulator.

For this reason, the charging methods aiming exclusively at maximising the coulombic efficiency, avoiding the activation of the secondary reactions, do not guarantee automatically the maximisation of the energetic efficiency as well.

This can happen, for example, for some charging methods such as that proposed by Satake et al. (Patent US 624 6216) wherein the charging current starts initially from a certain value and is progressively reduced when the activation of secondary reactions is detected.

Although in this case the losses due to secondary reactions are strongly reduced (one obtains a coulombic efficiency that this almost unitary), the lack of a precise knowledge of the remaining causes of energy dissipation entails an indetermination on the most suitable charging current value to be used in the initial phase of the charging process, wherein only the primary reactions are present, namely the chemical reactions transforming the absorbed charge into charge actually accumulated at the terminals of the accumulator and available for a subsequent discharge of the same accumulator.

From these indetermination, empirical criteria are often derived, which are extremely precautionary and which sometimes limit excessively both the initial charging current and the maximum voltage achievable by the accumulator during the charging process.

This can have negative consequences not only on the charging time, which obviously is remarkably slowed down by the use of low charging currents, but also on the overall energetic efficiency of the system, given that the battery chargers utilised usually tend to show a degradation of the efficiency for low levels of the output power.

In order to guarantee good performances, above all in terms of charging time and energetic efficiency, it is therefore fundamental to abandon the use of charging processes performed "blindly", and provide for programmed charging on the basis of an accurate knowledge of all the characteristics of the specific utilised accumulator.

This can be effected in an efficient way by suitable mathematical models allowing to simulate the behaviour of the accumulator and carry out also useful forecasts on the trend of the main physical quantities with varying operating conditions of the same accumulator during the charging process.

It is important to stress that the characteristics of an accumulator are in general affected by ageing. Therefore, it is appropriate to use mathematical models whose parameters can be updated during the life of the same accumulator by means of an appropriate characterisation process.

Obviously, in order to guarantee the practical feasibility of the use of such models in actual applications, it is fundamental that the above-mentioned process of characterisation be actually performable by means of a determined (possibly limited) number of measurements carried out on the field (i.e. when the accumulator is installed in the final system) in an automatic way, without the necessity to perform complicated lab tests and reducing down to the minimum the interruptions of service.

Hence, simulators based on physical-electrochemical models of the accumulator such as the one proposed by Notten et al. (Patent US0060160479) are generally unsuitable, given the great quantity of parameters of the model and the technical difficulty in performing a characterisation process of such parameters on the field.

For the above described aims, it is instead much more useful to resort to equivalent circuit models of the accumulator (Lin et al., patent US2011/0309838), such as the one shown in figure 1.

In the model, one has a resistor $R_0$ 101 that is responsible of the "instantaneous" variations of the voltage $V_B$ 110 on the accumulator in the presence of variations of current $I_B$ 105 flowing in the terminals of the same accumulator, and two $R_C$ circuits ($R_1$-$C_1$ 102 and $R_2$-$C_2$ 103) that model different dynamic effects of the accumulator. It is important to stress that the actual behaviour of the accumulator could be well described by a different number of RC circuits with respect to those shown in the figure, without that this limits in any way the general validity of what will be described in the following. The voltage generator with value $V_{OC}$ 104 represents the open circuit voltage of the accumulator.

The current $I_{acc}$ 106 indicates the current quantity actually supporting the primary chemical reactions within the accumulator, that, as it has been said in the foregoing, can differ from the current $I_B$ during the charging process as a consequence of the phenomena connected to the secondary reactions, such as for example water electrolysis provoking the known phenomenon of gassing in the lead batteries.

These phenomena are modelled by the secondary branch 107 that absorbs a current $I_g$ 108 describing the current absorption by the possible secondary reactions, and being in general function of the voltage $V_g$ 109 at the terminals of the secondary branch.

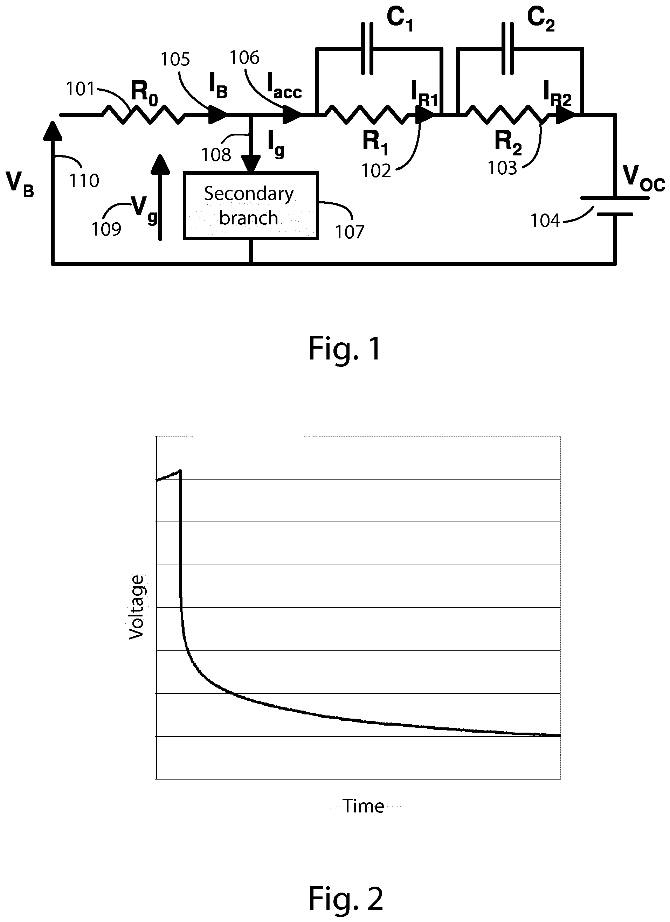

In the following dissertation, all the circuit elements of the model that are not part of the secondary branch (i.e. the elements through which current flows during the charging process also in presence of the only primary reactions) will be indicated as parameters of the primary branch. For the circuit of figure 1, the primary branch comprises $R_0$, $R_1$, $C_1$, $R_2$, $C_2$, and $V_{OC}$.

In general, the different parameters of the equivalent electrical model of the accumulator depend on the operating conditions of the same accumulator, in particular on the state of charge (SOC).

Hence, it is fundamental to characterise the trend of the parameters with varying SOC. To this end, one can think to carry out a series of parameters measurements, during a charging process, each time the state of charge comes out to be increased by a predetermined quantity.

In the state of the art, different methods have been proposed for the measurement of electric parameters of the accumulator.

Some of them are based on the estimation of frequency characteristics of the battery. For example, document EP2375487 describes a method of identification of the battery model of a battery able to be charged and discharged, the method comprising the steps of:

setting a battery model, which has a plurality of resistive and capacitive components as parameters;
inputting sequences of signals with different frequency components as electric current input on the battery;
measuring a voltage at the terminals of the battery when the signals are input on;
identifying a system based on a result of measurement of the voltage of the terminals;
calculating the frequency characteristics of the battery; and
estimating the parameters of the battery model on the basis of the calculated frequency characteristics.

Some characterization methods consist in the application of current waveforms to the accumulator and the evaluation of the corresponding time response of the voltage at its terminals. In particular, stopping the charging for a determined time period and evaluating the response of the voltage on the accumulator comes out to be convenient, as proposed for example by Denning (patent US7095211) and Paryani (patent US2011/0077879) and illustrated in figure 2.

During such pause of the charging process one performs a series of measurements of the voltage on the accumulator, and from the interpolation of such measured values one obtains a function of the time response, which allows to extrapolate the steady state value of the open-circuit voltage $V_{OC}$ in correspondence of the SOC value at hand. From such value of $V_{OC}$ and the value of $I_B$ as measured before the pause, one determines the remaining parameters by means of calculations carried out on the basis of the equivalent model of the accumulator. From the foregoing, one gathers that it is needed that the duration of the pause of the charging process is such that one can obtain an accurate estimation of the steady state value of the $V_{OC}$.

The described approach offers good performances in the estimation of the parameters of the primary branch in the absence of secondary reactions during the charging process. In these cases, indeed, the current $I_B$ measured at the terminals of the accumulator is exactly equal to the current $I_{acc}$ supporting the primary reactions (figure 1), therefore:

- The increase of SOC for which the measurement phase is to be effected can be directly deduced by integrating the current $I_B$ measurable at the terminals of the accumulator;
- In order to determine the values of the parameters of the primary branch, it is sufficient to determine the values of $V_B$ and $I_B$ that are directly measurable at the terminals of the accumulator in correspondence of the application of the particular considered current waveform.

It is well different instead the situation that one has when the secondary reactions activate, because in this case considering in any case $I_{acc}=I_B$ would entail an error in the estimation of both SOC and the various parameters of the primary branch. Unfortunately, however, $I_{acc}$ is not obviously determinable in such a direct way by means of current measurement at the terminals of the accumulator.

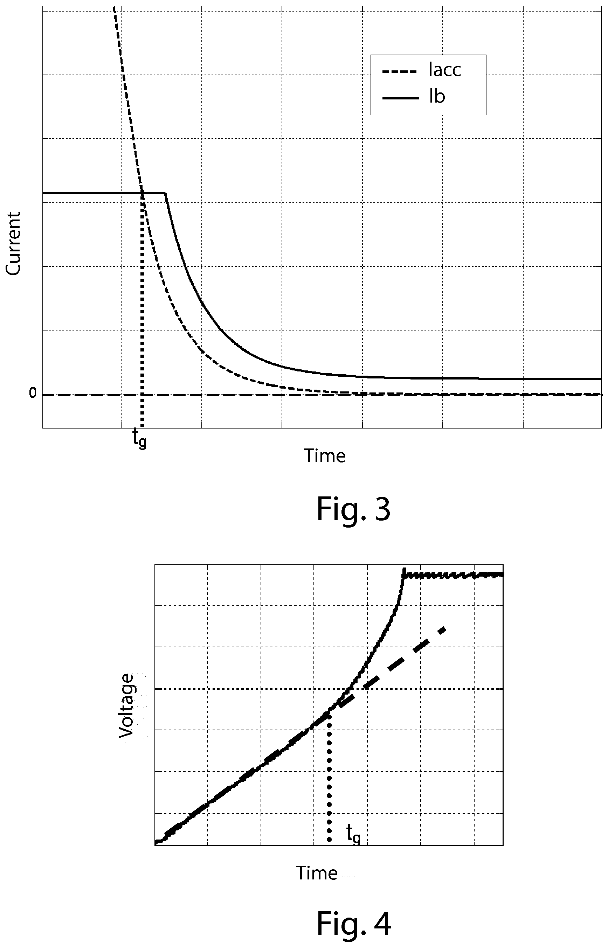

For such a reason, it is fundamental first of all to achieve individuating, during the charging process, the instant at which the secondary reactions activate, i.e. the time instant at which the current $I_B$ supplied to the accumulator exceeds the maximum current $I_{acc}$ that can be absorbed by the primary electrochemical reaction. This is illustrated in figure 3, which shows the trends of the two currents in a normal two-steps, constant current-constant voltage (CC-CV) charging process and in which the time instant at which the secondary reactions activate is indicated with $t_g$.

In some methods, such as those proposed by Satake et al. (patents US 6198254 and US 6246216), such time instant is determined as that at which the voltage on the accumulator exceeds a certain threshold.

In fact, the instant $t_g$ at which the secondary reactions activate can be individuated more correctly as the instant at which the time derivative of the voltage $V_B$ on the accumulator undergoes a rapid variation (figure 4).

This has been discussed also by Kwok (patent US6300763), who has proposed a method wherein, once determined the time instant at which the secondary reactions activate, one estimates the current actually useful to the primary reactions $I_{acc}$ according to a relationship connecting such a current to SOC, to the end of determining the coulombic efficiency of the accumulator. However, as discussed in the foregoing, the energy losses due to the activation of the secondary reactions are not the only ones to be taken into account to the end of determining the energetic efficiency, since a portion of the energy supplied to the accumulator during the charging process is dissipated on the resistors of the primary branch of the model, wherein the values are, by the way, heavily influenced by the activation of secondary reactions within the accumulator.

By way of example, one can make reference to the circuit in figure 1. In order to simplify the analysis, one assumes to be able to neglect the capacitive components of the primary branch (assumption that typically can be made in the normal charging processes characterised by variations of voltage and current on the accumulator that are relatively slow). In this case, the two resistors can be considered in series and can be substituted by a total equivalent resistor $R_{tot}=R_1+R_2$.

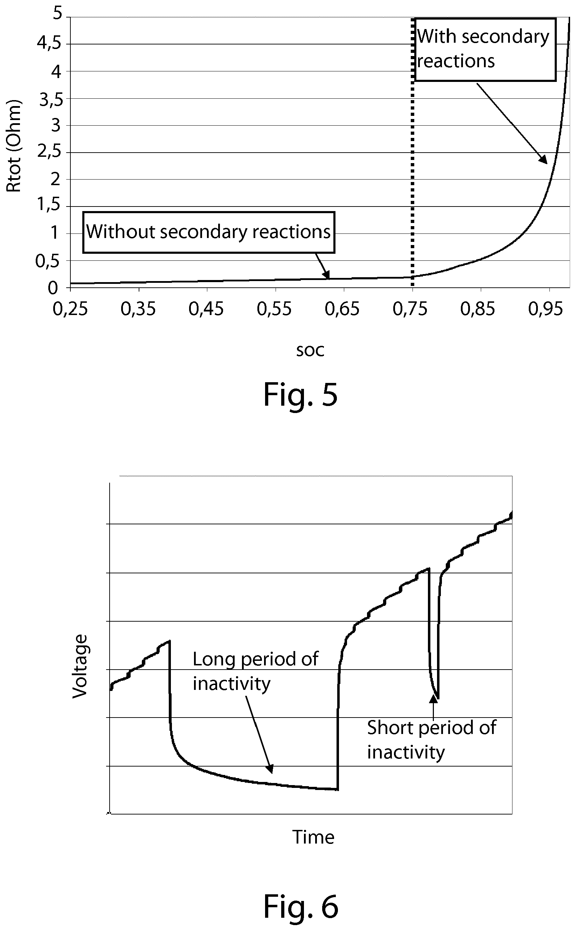

The graph in figure 5 shows experimental data relevant to the trend of $R_{tot}$ as a function of SOC for a lead acid battery.

It is evident that the resistor has a rapid increase at the activation of secondary reactions, which comes out to be coherent with the decrease of the current $I_{acc}$ useful to the primary reaction (figure 1).

In order to determine the impact of the secondary reactions on the parameters of the primary branch of the model, one could think to unite the two methods of characterisation as above discussed, by simply estimating the activation instant of the secondary reactions and the current $I_{acc}$ as a function of the state of charge, and by providing a series of interruptions of the charging process suitable to evaluate the time response of the voltage on the accumulator also during the phase wherein the secondary reactions are present.

However, such a solution could have a series of remarkable disadvantages.

First of all, experimental results show that the presence of secondary reactions extend significantly the minimum duration of each pause of the process needed for a correct estimation of the $V_{OC}$ at operating speed.

But, still more important is the fact that the activation instant of the secondary reactions, as well as the subsequent behaviour of the accumulator in the presence of secondary reactions, depends on the current $I_B$ used to charge the accumulator and the state of charge of the same accumulator at the beginning of the charging process.

This means that the possible parameters values, derived by means of the union of the described methods into a charging process, characterised by a given initial value of SOC and a given charging current, would not allow an accurate estimation of the performances (and in particular the energetic efficiency) of the accumulator in correspondence of any other charging process carried out by starting from a different initial value of SOC and a different charging current.

In order to overcome this problem, one would need to apply the existent methods by carrying out $m \cdot n$ charging cycles, wherein $m$ represents the number of different charging currents that one wants to explore and $n$ represents the number of different initial states of charge that one wants to explore.

In the practice, a so time-consuming procedure would be suitable possibly to be carried out only in the step of production of the accumulator, and not during the life of the same accumulator. Moreover, the so determined values could deviate from the real ones both for the inevitable ageing of the accumulator during its use and for the different conditions in which the accumulator would be used in the practical applications.

For the given aims, it is instead necessary to realise a rapid characterisation method, which allows to obtain a good accuracy in the forecasts of the performances of the accumulator in all the possible operating conditions by means of a minimum number of tests.

In view of the foregoing, it comes out that is not possible to obtain such a method by means of the simple union of the different existent state-of-the-art methods as above discussed.

It is object of the present invention a method for the characterisation of the parameters of the equivalent model of the accumulators which allows to overcome the limits of the traditional methods, as well as the means to realise the method.

It is subject-matter of the invention a method for the characterisation of electric parameters of the equivalent circuit of an accumulator as a function of its state of charge, the accumulator presenting two terminals, comprising a step A.1 of identification of the equivalent electric model of the accumulator, a step A.2 of characterisation of the primary chemical reactions of the accumulator, i.e. reactions which produce charge accumulation at the terminals of the accumulator, a step A.3 of characterisation of the secondary chemical reactions of the accumulator, i.e. reactions that do not produce charge accumulation at the terminals of the accumulator, and a step A.4 of calculation of the electric parameters, characterised in said steps being as follows:

A.1) defining an equivalent electric circuit characterised by a set of electric parameters, such a circuit comprising at least a primary branch including elements that during a charging process are traversed by current even in the presence of the only primary chemical reactions of the accumulator and to which respective primary parameters $P_i$ are associated, with i positive integer, and at least a secondary branch including elements that during a charging process are traversed by current only in the presence of secondary chemical reactions of the accumulator and to which respective secondary parameters are associated;

A.2) characterising the primary parameters $P_i$ of the primary branch, by repetitively executing, during an initial step of at least an accumulator charging process wherein the secondary reactions are negligible, whenever the accumulator state of charge comes out to be incremented of a pre-determined quantity obtained by a measurement of the state of charge during the whole accumulator charging process, the following sub-steps:

A.2.1) applying to the accumulator a pre-determined current and/or voltage waveform;
A.2.2) measuring, during a time interval, a pre-determined number of voltage values at the terminals of the accumulator and/or values of current flowing into the accumulator;
A.2.3) interpolating said voltage and/or current values measured in step A.2.2, determining an interpolating function which reconstructs the time response of the voltage or current on the accumulator as a consequence of application of said waveform, and from said function obtaining the values of the electrical parameters of said at least a primary branch;
thus obtaining a set of values for each primary parameter $P_i$, and executing subsequently the following sub-step:
A.2.4) for each primary parameter $P_i$ of said at least a primary branch, determining, by interpolation of said set of values, a function linking the value of the parameter to the generic increment of state of charge during the charging process when only the primary reactions are active;

A.3) characterising the parameters of the at least a secondary branch, by repetitively executing, during time instants subsequent to said initial step of at least an accumulator charging process, the following subsequent steps:

A.3.1) a testing step for testing the presence of secondary reactions wherein, in a given instant, one measures the voltage and current at the accumulator terminals, and one determines the presence of secondary reactions if said voltage and current values deviate of a pre-determined quantity from the voltage and current values as calculated by means of the equivalent circuit as defined in step A.1, assuming that the current absorbed in the at least a secondary branch vanishes and determining the parameters of the at least a primary branch by extrapolating the functions determined in step A.2.4, and one memorises: first time instant $t_g$ wherein the presence of secondary reaction is determined, current $I_B(t_g)$ measured at the accumulator terminals at instant $t_g$ and the increment of state of charge $\Delta SOC(t_g)$ obtained from the beginning of the charging process till time instant $t_g$ as comes out from the state of charge measurements of step A.2;
A.3.2) a sampling step wherein one memorises a pre-determined number of voltage and current values at the accumulator terminals in correspondence of time instants subsequent to said time instant $t_g$;

A.4) determining, in any time instant subsequent to the end of said step A.3, mathematical functions allowing to calculate, for a hypothetical charging process, the primary electrical parameters $P_i$ of the accumulator in correspondence of any value of the state of charge both in the absence and in the presence of secondary reactions, carrying out the following sub-steps:

A.4.1) determining, on the basis of a value of the initial state of charge $SOC_0$ of said at least a charging process and the values of $t_g$, $I_B(t_g)$ and $\Delta SOC(t_g)$ stored in step A.3.1, a function $I_{acc}(SOC)$, linking the maximum current $I_{acc}$ that can be absorbed by the at least a primary branch and the state of charge SOC, that satisfies the condition:

$$I_{acc}\left[SOC_0 + \Delta SOC\left(t_g\right)\right] = I_B\left(t_g\right)$$

A.4.2) determining, on the basis of the function $I_{acc}(SOC)$ and the accumulator equivalent circuit, the values of the voltage and current at the terminals of the at least a secondary branch in correspondence of the values of voltage and current at the terminals of the accumulator stored in step A.3.2, and, by interpolating such values, determining a function $V_g(I_g)$ expressing the relationship between voltage $V_g$ and current $I_g$ at the terminals of the at least a secondary branch;

A.4.3) determining mathematical functions connecting primary parameters $P_i$ and the state of charge both in the absence and in the presence of secondary reactions, carrying out for each primary parameter $P_i$ the following sub-steps:

A.4.3.1) determining, by interpolation of the values of said set of values of the parameters referred of step A.2, an interpolating function $f_{pi}(SOC)$, expressing the relationship between the primary parameter $P_i$ and the state of charge when only the primary reactions are active, and

A.4.3.2) determining a function $f_{si}(SOC)$ expressing the relationship between the primary parameter $P_i$ and the state of charge when also the secondary reactions are active, such a function coinciding with $f_{pi}(SOC)$ if the value of the primary parameter $P_i$ as a function of SOC is not influenced by the presence of secondary reactions, otherwise it being determined by circuit analysis on the basis of the accumulator equivalent electric circuit as defined in step A.1, the function $I_{acc}(SOC)$, the function $V_g(I_g)$ and the parameters whose function $f_{si}(SOC)$ coincides with $f_{pi}(SOC)$.

The primary branch is, in particular, characterised by the interconnection of elements through which, during the charging process, the current flows also in the presence of the only reversible primary chemical reactions transforming the electric charge absorbed during a charging process into electric charge accumulated at the terminals of the accumulator and available for a subsequent discharge process of the accumulator.

The secondary branch is, in particular, characterised by the interconnection of circuit elements through which, during the charging process, the current flows only in the presence of irreversible secondary chemical reactions which do not transform the electric charge absorbed during the charging process into electric charge accumulated at the terminals of the accumulator and available for a subsequent discharging process of the accumulator.

It is specified that, in some situations, the above primary and secondary reactions are also indicated respectively as main and parasite reactions, as well as that the details of their definition can vary in some way with respect to the definition given in the above description. However, the skilled person will recognise the general validity of the method, regardless of the definitions of the types of chemical reactions involved in the charging process. Indeed, the primary and secondary chemical reactions are modelled respectively in the primary and secondary branches of a circuit model of the accumulator and therefore can be specified each time, depending on the type of the accumulator and its behaviour. For the invention, the important thing is that the reactions producing charge accumulated and available for subsequent discharge are distinguished from the reactions that instead do not.

According to an aspect of the invention, the initial state of charge $SOC_0$ is not known before said at least a charging process, and in place of step A.4.1 the following step is executed:

A.4.1bis) determining the initial state of charge $SOC_0$ of said at least a charging process and a mathematical function $I_{acc}(SOC)$ connecting the maximum current $I_{acc}$ that can be absorbed by the at least a primary branch and the state of charge SOC, carrying out the iterative procedure consisting of the following steps:

A.4.1.1) assuming a value of $SOC_0$;

A.4.1.2) on the basis of the assumed value of $SOC_0$ and the values of $t_g$, $I_B(t_g)$ and $\Delta SOC(t_g)$ stored in step A.3.1, calculating a function $I_{acc}(SOC)$ satisfying the condition:

$$I_{acc}\left[SOC_0 + \Delta SOC\left(t_g\right)\right] = I_B\left(t_g\right)$$

A.4.1.3) calculating the state of charge increment $\Delta SOC_S$ obtained by integrating the current $I_{acc}$, calculated according to the function determined in step A.4.1.2, from instant $t_g$ till a pre-determined instant of said at least a charging process of steps A.2 and A.3, and calculating the state of charge $SOC_f$ of the charging process in said pre-determined instant, estimated on the basis of the following relationship:

$$SOC_f = SOC_0 + \Delta SOC\left(t_g\right) + \Delta SOC_S$$

A.4.1.4) calculating the difference between the state of charge actually achieved in said pre-determined instant of said at least a charging process and the state of charge $SOC_f$ estimated in step A.4.1.3;
A.4.1.5) if the difference calculated in step A.4.1.4 exceeds a pre-determined quantity, increasing the assumed value of $SOC_0$ by a quantity that is function of said difference, in particular proportional to said difference, and repeating steps A.4.1.2-A.4.1.5, otherwise terminating the iterative procedure.

According to an aspect of the invention, for a pre-determined number of repetitions of step A.2.2 one performs a first group of measurements wherein:

- the duration of the time interval wherein each measurement is carried out is such to allow the measurement of all the parameters of said at least a primary branch, and wherein the measured parameters values are also utilised to define mathematical functions expressing a subset of the parameters of said at least a primary branch as a function of a different subset of the parameters of said at least a primary branch assumed as set of reference parameters; and wherein the remaining repetitions of step A.2.2 comprise a second group of measurements, wherein:
- the duration of the time interval is such to allow only the measurement of said reference parameters, and wherein the values of the remaining parameters of said at least a primary branch are obtained from the values of said reference parameters by extrapolation using the functions calculated during the first group of measurements.

Since the constants in the transient phase wherein one applies the waveform of voltage or current to the accumulator have different observation times, the measurement time must be sufficiently long to measure all of them.
According to an aspect of the invention, function $I_{acc}(SOC)$ is:

$$I_{acc} = \frac{A_0}{1 - SOC_i}\left(\frac{1}{SOC} - 1\right),$$

$SOC_i$ being the initial state of charge of said hypothetical charging process, and $A_0$ being a real value constant coefficient, determined in step A.4.1 according to claim 1, or in step A.4.1bis in the method according to claim 2.
According to an aspect of the invention, function $V_g(I_g)$ determined in step A.4.2 is:

$$V_g = V_{g0} + a_1 \frac{I_{Bref}}{I_B} I_g + a_2 \left(\frac{I_{Bref}}{I_B}\right)^2 I_g^{\,2},$$

during the time intervals of the process wherein the charging process is at constant current, i.e. wherein the charging system connected to the accumulator behaves as a current generator, $I_{Bref}$ being a generic value of the current flowing through the accumulator terminals that is taken as a reference value, $V_{g0}$, $a_1$ and $a_2$ being real value constant coefficients determined by interpolation of at least three values of $I_g$ and $V_g$ obtained in step A.4.2,
and instead function $V_g(I_g)$ is of the type

$$V_g = \frac{I_g - q_g}{m_g},$$

during the time intervals of the process wherein the charging process is at constant voltage, i.e. wherein the charging system connected to the accumulator behaves as a voltage generator, $q_g$ and $m_g$ being two real-value coefficients whose value takes into account the voltage applied to the accumulator during the specific time interval wherein the charging process is at constant voltage.
According to an aspect of the invention, the at least a primary branch of the accumulator equivalent circuit defined in step A.1 comprises a determined number of resistors and at least a voltage generator whose value $V_{OC}$ models the open-circuit voltage of the accumulator.

According to an aspect of the invention, for each resistor belonging to the at least a primary branch of the accumulator equivalent circuit, the function $f_{pi}(SOC)$ determined in step A.4.3.1 is:

$$f_{pi} = \alpha m_{Ri0} \left( SOC - SOC_i \right) + R_{i0} \, ,$$

$SOC_i$ being the initial state of charge of said hypothetical charging process, $m_{Ri0}$ and $R_{i0}$ being real-value constant coefficients determined by means of interpolation of at least two values of said resistor as measured in step A.2, and $\alpha$ being a coefficient whose value is determined each time for each charging process according to the relationship:

$$\alpha = \frac{1}{m_{Ri0}} \frac{f_{si}\left( SOC\left( t_g \right) \right) - R_{i0}}{SOC\left( t_g \right) - SOC_i} \, ,$$

wherein $t_g$ is the instant at which the secondary reactions start, determined as the instant at which the current $I_{acc}$ equals the current $I_B$ flowing through the accumulator terminals, $SOC(t_g)$ is the value of the state of charge calculated at $t_g$, and $f_{si}(SOC(t_g))$ is the value of the function $f_{si}(SOC)$, as determined in step A.4.3.2, calculated in correspondence of said value of $SOC(t_g)$.

According to an aspect of the invention, function $f_{pi}(SOC)$ as determined in step A.4.3.1 and function $f_{si}(SOC)$ as determined in step A.4.3.2 for the voltage generator of value $V_{OC}$ coincide and are of the type:

$$f_{pi}(SOC) = f_{si}(SOC) = m_V SOC + q_V \, ,$$

$m_v$ and $q_v$ being real-value constant coefficients determined by interpolation of at least two values of $V_{OC}$ determined in step A.2.

According to an aspect of the invention, steps A.2 and A.3 are carried-out in correspondence to a given number of accumulator working temperature T to the end of characterising the parameters of the accumulator equivalent circuit even as a function of the working temperature, determining in step A.4, by interpolation of the measured values:

- a function $I_{acc}(SOC, T)$ expressing the relationship between the maximum current that can be absorbed by the at least a primary branch and any values pair (SOC,T), and a function $V_g(I_g, T)$ expressing the relationship between the voltage at the terminals of the at least a secondary branch and any values pair ($I_g$, T),

and, for each parameter of the at least a primary branch, determining:

- a function $f_{pi}(SOC, T)$, each time different depending on the parameter $P_i$, that expresses the relationship between the parameter and any values pair (SOC,T) when only the primary reactions are active, and a function $f_{si}(SOC,T)$, each time different depending on the parameter $P_i$, expressing the relationship between the parameter and any values pair (SOC,T) when also the secondary reactions are active, such a function $f_{si}(SOC,T)$ coinciding with $f_{pi}(SOC,T)$ if the value of the parameter as a function of (SOC,T) is not influenced by the presence of secondary reactions, otherwise being determined by circuit analysis on the basis of the accumulator equivalent circuit, the functions $I_{acc}(SOC,T)$, $V_g(I_g, T)$ and the parameters whose function $f_{si}(SOC,T)$ coincides with $f_{pi}(SOC,T)$.

It is further subject-matter of the invention a charging system for electric energy accumulators, such a system being provided with an input section and an output section and is able to take energy from a source by the input section and to give energy to the accumulator by the output section, the system comprising the following elements:

- a power section, suitable to provide electric energy to the accumulator and to apply to the same accumulator pre-determined voltage and/or current waveforms,
- a voltage measurement device for measuring voltage at the terminals of the accumulator,
- a current measurement device for measuring current flowing into the terminals of the accumulator,
- a memory device, and
- an electronic calculation device,

said system being suitable to perform any charging process of the accumulator and the method of characterisation of the electric parameters of the electric equivalent circuit according to the method of the invention, wherein:

- said power section is configured to apply to the accumulator a current and/or voltage waveform according to step A.2.1 ;
- said voltage measurement device and said current measurement device are configured to perform the measurements of steps A.2.2, A.3.1, A.3.2;
- said calculation device perform the calculations of steps A.2, A.3 and A.4;
- said memory device is used to store the data calculated by the method.

It is further subject-matter of the present invention a charge control system for an electric energy accumulator receiving energy from an external battery charger, which includes an input section and an output section and is able to take energy from a source by the input section and to give energy to the accumulator by the output section having two terminals, said charge control system being characterized in that it comprises two control terminals suitable to be connected, directly or by means of one or more devices in series, at the two terminals of said output section of the battery charger, and in that it further comprises:

- a load device suitable to absorb electric current by said two control terminals;
- a voltage measurement device for measuring the voltage at the terminals of the accumulator;
- a current measurement device for measuring the current flowing into the accumulator terminals,
- a memory device, and
- a calculation device,

said system being suitable to execute the method of characterization of the electrical parameters of the accumulator electric equivalent circuit according to the method of the invention, wherein:

- said load device is configured to absorb electric current by said two control terminals during pre-defined time intervals in such a way that a pre-defined current and/or voltage waveform is applied to the accumulator, according to step A.2.1;
- said voltage measurement device and said current measurement device are configured to perform the measurements of steps A.2.2, A.3.1, A.3.2;
- said calculation device performs the calculations of steps A.2, A.3 and A.4; said memory device is configured to store the data calculated in the method.

It is here specified that, although both the just described systems are able to implement the discussed method of characterisation, there is a substantial difference in terms of functionality between the charging control system and the charging system as described above. Indeed, the above charging system is also able to implement a charging process of the accumulator by taking out energy from the source and giving it to the same accumulator. Such functionality is not guaranteed in the above charging control system, which is instead understood as an additional device suitable to be connected to the terminals of a battery charger utilised to carry out the charging process of the accumulator.

According to an aspect of the invention, the system further comprises at least a switching block connected in series between the terminals of the output section of the battery charger and the accumulator terminals, such a switching block being configured in such a way to electrically disconnect the accumulator from the output section of the battery charger during the time intervals wherein the load device absorb current, and to electrically connect the accumulator to the output section of the battery charger in the remaining time intervals,

The concept of electric connection can be implemented in several different ways, because one can think to insert:

- switches that physically disconnect two circuit portions;
- devices that do not disconnect physically the two portions of the circuit, but create a situation of "high impedance", as a matter of fact, interrupting the passage of current.

According to an aspect of the invention, the system comprises also the following elements:

- a voltage generator provided with two terminals suitable to be electrically connected, directly or by one or more devices in series, to the terminals of the output section of the battery charger, said voltage generator being suitable to establish a voltage difference between its terminals;
- at least a switching block connected in series between the terminals of said voltage generator and the terminals of the output section of the battery charger, such switching block being configured in such a way to electrically connect the voltage generator to the output section of the battery charger during the time intervals wherein the load device absorbs current, and to electrically disconnect the voltage generator from the output section of the battery charger in the remaining time intervals.

According to an aspect of the invention, the system further comprises a power section suitable to supply current by said two control terminals.

It is further subject-matter of the invention a computer program, characterised in that it comprises code means configured in such a way that, when they are executed by a computer, perform the calculations of steps A.2, A.3 and A.4 of the method according to the invention.

It is further subject-matter of the invention a memory support, characterised in that it has stored on itself the program according to the invention.

The invention will be no described by way of illustration but not by way of limitation, with particular reference to the drawings of the enclosed figures, wherein:

- Figure 1 shows an equivalent circuit model of the accumulator;
- Figure 2 shows a time response of the voltage on the accumulator to a current step;
- Figure 3 shows a trend of $I_{acc}$ and $I_B$ in a CC-CV process;
- Figure 4 shows a time trend of the voltage on the accumulator;
- Figure 5 shows a trend of $R_{tot}$ as a function of SOC;
- Figure 6 shows a characterisation procedure with two measurements steps of different duration;
- Figure 7 shows a relationship between $I_g$ and $V_g$ in the CC and CV charging phases.

**Detailed description of the preferred embodiments of the invention**

The object of this invention is the introduction of a method for the characterisation of the parameters of the equivalent model of an accumulator.

The method is based on the description of the accumulator by means of a suitable circuit model, such as that shown in figure 1, that is, in general, characterised by at least a primary branch, in the components thereof the current flows even in the absence of secondary reactions, and at the least a secondary branch in the component thereof the current flows only in the presence of secondary reactions.

As explained above, the parameters of the model depend on the operating conditions of the accumulator, in particular on the state of charge (SOC). To the end of being able to simulate the behaviour of the accumulator, it is therefore appropriate to determine the mathematical functions that allow to calculate the values of the parameters with varying state of charge.

An object of the present invention is to propose a method of characterisation of the above electric parameters, which allows to determine such functions.

The proposed method consists in four main steps:

- a step of identification of the equivalent model of the accumulator;
- a step of characterisation of the primary reactions, carried out during at least a charging process of the accumulator wherein one carries out measurements of a given number of electric parameters of the primary branch in the absence of secondary reactions;
- a step of characterisation of the secondary reactions, carried out during the above at the least a charging process when also the secondary reactions are activated;
- a calculation step, which can be carried out in any moment subsequent to the above at least a charging process, wherein one determines mathematical functions which allow to extrapolate the values of the electric parameters in correspondence of a determined state of charge, both in the absence and in the presence of secondary reactions.

The identification step of the equivalent model of the accumulator consists in the definition of an equivalent electric circuit, characterised by a set of electric parameters with which it is possible to model the behaviour of the accumulator, such circuit being characterised by the presence of:

- at least a primary branch, characterised by the interconnection of circuit elements in which, during a charging process, the current flows also in the presence of the only primary chemical reactions which produce charge accumulation at the terminals of the accumulator;
- at least a secondary branch, characterised by the interconnection of circuit elements in which, during the charging process, the current flows only in the presence of secondary chemical reactions that do not produce charge accumulation at the terminals of the accumulator.

Once one has defined the circuit model of the accumulator, one executes the steps of characterisation of the primary reactions, which can be carried out as above explained by providing a given number of measurements steps, wherein one applies to the accumulator a determined current and voltage waveform (for example, the charging current of the accumulator is fixed to 0) and the electric parameters of the primary branch are determined.

Since the parameters varies with the SOC, it is appropriate to carry out the above operation in correspondence of a determined number of different values of SOC.

Once such measurements are performed, one interpolates the values of the measured parameters to obtain the mathematical functions which allow to extrapolate the value of the parameters of the branches of the primary reactions for any increment of SOC before the activation of the secondary reactions.

Since the above measurements are carried out when only the primary reaction is activated, the increment of SOC from the beginning of the charge can be for example estimated simply by the counting of the charge introduced in the accumulator (coulomb counting).

On the basis of the above description, it is therefore possible to state that, in general, the steps of characterisation of the primary reactions consists in the performing of the following sub-steps each time the state of charge of the accumulator comes out to be increased by a predetermined quantity before the activation of the secondary reaction:

- applying a predetermined current and/or voltage waveform to the accumulator;
- measuring, within a time interval, a given number of voltage values at the terminals of the accumulator and/or current flowing in the accumulator;
- interpolating the above measured voltage and/or current values, determining an interpolating function that reconstructs the time response of the voltage or the current on the accumulator as a consequence of the application of the above mentioned waveform, and, from such function, obtaining the values of the electric parameters of the primary branch in correspondence of the SOC increments at which one carried out the above sub-steps;
- determining, by integration of the above mentioned measured values of the parameters of the primary branch, mathematical functions that allow to extrapolate such parameters for any increment of state of charge before the activation of the secondary reactions during the charging process.

It is important to stress that the measurement of the whole set of electric parameters by means of the time response of the voltage on the accumulator to a current step can be a relatively slow operation, owing to the fact that one needs to wait a time sufficient (sometimes of the order of tens of minutes) to allow the relaxing of the voltage on the accumulator (figure 2).

Fortunately, for some types of currently used accumulators, in presence of the only primary reactions, the relationships between the parameters of the accumulator and the state of charge can be well described by linear functions, which therefore can be calculated on the basis of only two measurements in correspondence of two different SOC values.

Moreover, in order to reduce, down to the minimum, the waste of time during the charging process wherein one carries out the characterisation, it is also possible to resort to a particular solution, which provides two different groups of measurements:

- a first group of measurements, whose duration is such to allow the measurement of all the parameters of the branches of the primary reactions, wherein the measured values of the parameters are also utilised to define mathematical functions allowing to express a determined number of parameters in the primary branch as a function of a determined subset of parameters, selected among all the parameters of the primary branch and assumed as reference parameters;
- a second group of measurements of reduced duration, whose duration is such to allow only the measurement of the above-mentioned reference parameters, and wherein the remaining parameters of the primary branch are obtained by extrapolation, by using the values of the reference parameters as measured during the measurements belonging to such second group and the functions calculated during the above first type of measurements.

For example, with reference to the model of figure 1, one can state that typically the time constant $R_2C_2$ is significantly larger than the $R_1C_1$. Hence, the estimation of the parameters of the $R_2$-$C_2$ circuit extends the necessary minimum duration of the pauses performed during the charging process.

According to what has been explained above, in order to accelerate the characterisation process, one can think to carry out a first pause that is sufficiently long and wherein one determines all the model parameters and the functions connecting the components of the $R_2$-$C_2$ circuit to those of the $R_1$-$C_1$ circuit, and a subsequent pause having duration shorter than the first one, wherein one determines the values of $R_0$, $R_1$, and $C_1$, extrapolating from these the corresponding values of $R_2$, $C_2$, and $V_{OC}$ on the basis of the previously calculated functions.

This is illustrated in figure 6, which shows to measurements steps of different duration during the step of characterisation of the primary reactions.

After having performed the step of characterisation of the primary reactions, one performs a step of characterisation of the secondary reactions. As stated, in the presence of secondary reactions, a part of the current supplied to the accumulator is not useful to the charging of the same, rather to support secondary reactions at hand.

From an analytical point of view, it is possible to determine the instant $t_g$ at which the secondary reactions activate (figure 3 and figure 4), as well as the one at which the voltage read on the accumulator differs of a predetermined quantity from that estimated by using the equivalent model of the accumulator, whose parameters are calculated by using the mathematical functions determined in the step of characterisation of the primary reactions, and wherein the current $I_g$ absorbed by each secondary branch is assumed equal to 0.

Since $t_g$ is the instant at which the secondary reactions activate, the total increment of SOC from the beginning of the charging till $t_g$ ($\Delta SOC(t_g)$) can be obtained directly by the counting of the charge introduced in the accumulator. This obviously is no more true after the activation of the secondary reactions.

Once determined $t_g$, one waits for the end of the process of charging, measuring and storing a determined number of values of voltage $V_B$ as read at the terminals of the accumulator and the current $I_B$ flowing in its terminals in correspondence of different time instants, among which there is the instant $t_g$.

In general, it is also possible to provide for a further series of measurements of parameters of the primary reactions of the primary branch in this second step, taking into account in any case the difference between $I_{acc}$ and $I_B$.

Therefore, summarising, the step of measurements in presence of secondary reactions consists in the following sub-steps:

- determining the instant $t_g$ at which the secondary reactions activate and the increment ($\Delta SOC(t_g)$) of the state of charge at the instant $t_g$;
- storing a determined number of values of voltage $V_B$ and current $I_B$ on the accumulator, among which the voltage and current at the instant $t_g$.

After the two steps described above, the proposed method provides for a calculation step, comprising different sub-steps.

First of all, one needs to determine a function $I_{acc}(SOC)$ allowing to calculate the current $I_{acc}$ as a function of the state of charge. Such function can be conveniently chosen so as to satisfy the following condition:

$$I_{acc}\left[ SOC\left(t_g\right) \right] = I_B\left(t_g\right), \qquad (1)$$

i.e. that at the instant $t_g$ the maximum current that can be absorbed by the primary reactions is equal to the current $I_B$ that flows at the terminals of the accumulator.

At this point, it is important to stress that the state of charge of the accumulator at the instant $t_g$ is given by the sum of the measured increment of state of charge ($\Delta SOC(t_g)$) and the state of charge $SOC_0$ that the accumulator got at the beginning of the characterising charging process:

$$SOC\left(t_g\right) = SOC_0 + \Delta SOC\left(t_g\right). \qquad (2)$$

In general, it is not necessarily true that $SOC_0$ is known in a precise way, therefore the proposed method provides a possible iterative step wherein one determines the initial state of charge and the corresponding function $I_{acc}(SOC)$. Such iterative step consists of the following steps:

1) Assuming a value of $SOC_0$;

2) Calculating a function $I_{acc}(SOC)$ satisfying the condition:

$$I_{acc}\left[ SOC_0 + \Delta SOC\left(t_g\right) \right] = I_B\left(t_g\right) \qquad (3)$$

3) Calculating the estimated state of charge $SOC_f$ in a predetermined instant of the charging process as:

$$SOC_f = SOC_0 + \Delta SOC\left(t_g\right) + \Delta SOC_S ,\qquad(4)$$

$\Delta SOC_S$ being the increment of the state of charge as obtained by counting the charge accumulated by the accumulator from the time instant $t_g$ to the above-mentioned predetermined time instant of the charging process by virtue of the only current $I_{acc}$;

4) Calculating the difference between the state of charge that has been actually achieved in the above instant of the characterisation charging process and the state of charge $SOC_f$ as estimated in the previous step;

5) If the above difference exceeds a predetermined quantity, increasing the initial state of charge $SOC_0$ of a quantity that is function of the same difference (in particular proportional to such a difference) and repeating the steps 2)-4), otherwise exiting the iterative procedure.

Concerning the function $I_{acc}(SOC)$, experimental results indicate that it can be conveniently expressed as follows:

$$I_{acc} = \frac{A_0}{1-SOC_i}\left(\frac{1}{SOC}-1\right),\qquad(5)$$

$SOC_i$ being the initial state of charge of the charging process and $A_0$ being a real-values constant coefficient determined by the equation (1).

After having determined the trend of $I_{acc}$, it is possible to determine the relationship $V_g(I_g)$ linking the voltage $V_g$ and the current $I_g$ at the terminals of the secondary branch. This relationship is obtained by interpolating the values of $I_g$ and $V_g$ that one can obtain by starting from the values of $V_B$ and $I_B$ stored during the measurement step in the presence of secondary reactions, taking into account the relationship $I_g=I_B-I_{acc}$ of the circuit model of the accumulator.

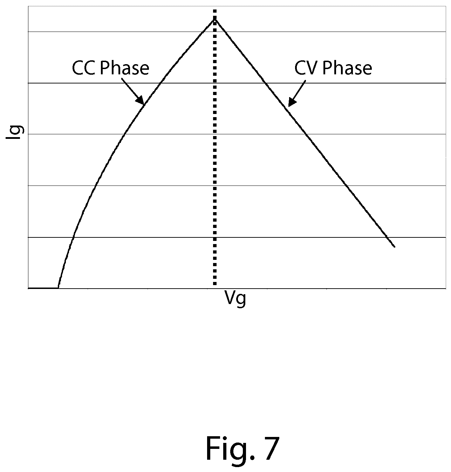

The relationship $V_g(I_g)$ can have in general two different trends, depending on the fact that the charging process of the accumulator is conducted at constant current (CC) or constant voltage (CV). This is illustrated in figure 7 that shows the trend of $I_g$ as a function of $V_g$ for a generic of CC-CV charging process on a lead battery.

In particular, with reference to figure, it can be convenient to consider a relationship $V_g(I_g)$ that is quadratic in the CC step and linear in the CV step, according to the following equation:

$$V_g = \begin{cases} V_{g0} + a_1 \dfrac{I_{Bref}}{I_B} I_g + a_2 \left(\dfrac{I_{Bref}}{I_B}\right)^2 I_g{}^2, & \text{in step CC} \\[4mm] \dfrac{I_g - q_g}{m_g}, & \text{in step CV} \end{cases}\qquad(6)$$

Wherein:

- $V_{g0}$, $a_1$ and $a_2$ are real-values constant coefficients determined by interpolation of at least three values of $I_g$ and $V_g$ obtained by measuring at least three pairs $(V_B, I_B)$ during the CC step of the charging process;
- $q_g$ and $m_g$ are two real-values coefficients whose value can be each time determined by the determination of at least two pairs $(V_g, I_g)$ calculated by the electric model of the accumulator;
- $I_{Bref}$ is a reference value of the current flowing in the terminals of the accumulator that can be chosen for example equal to a current value $I_B$ as measured in the characterisation charging process. The presence of $I_{Bref}$ and $I_B$ in the relationship $V_g(I_g)$ models the fact that, in fact, the current $I_g$ in a given instant has a value that is also connected to the current $I_B$ flowing in that given instant in the accumulator.

Once the initial state of charge $SOC_0$ of the characterisation charging process and the functions for $I_{acc}$ and $V_g(I_g)$ for the parameters of the secondary branch are determined, one needs to determine the functions that express the parameters of the primary branch. As above stated, such parameters can be affected in general by the presence of the secondary reactions (figure 5), and therefore require the use of two different functions expressing their trend as a function of SOC both in the absence and in the presence of secondary reactions.

For example, with reference to figure 5, the progression of the total resistance $R_{tot}$ as a function of SOC can be expressed by:

- A first function, determined by the interpolation of the one or more values of $R_{tot}$ as measured during the step of characterisation of the primary reactions, which expresses the relationship connecting $R_{tot}$ and SOC in the absence of secondary reactions;
- a second function, which expresses the relationship connecting $R_{tot}$ and SOC in the presence of secondary reactions and derived in an indirect way by means of a circuit analysis based on the equivalent model of the accumulator and on the knowledge of the previously calculated functions $I_{acc}(SOC)$ and $V_g(I_g)$. With reference to the circuit of figure 1, and neglecting the capacitors $C_1$ and $C_2$, such function can be written as follows:

$$R_{TOT}(SOC) = \frac{V_g - V_{OC}(SOC)}{I_{acc}(SOC)}. \qquad (7)$$

In general, the proposed method provides therefore for the definition of two different mathematical functions for each parameter $P_i$ of the primary branch:

- a function $f_{pi}(SOC)$, each time different depending on the parameter, which expresses the relationship between the parameter and SOC when only the primary reactions are active, and is determined by interpolation of the one or more values of the parameters as measured during the step of characterisation of the primary reactions;
- a function $f_{si}(SOC)$, each time different depending on the parameter, which expresses the relationship between the parameter and SOC when also the secondary reactions are active, such function coinciding with $f_{pi}(SOC)$ if the value of the parameter as a function of SOC is not influenced by the presence of the secondary reactions, otherwise being different from $f_{pi}(SOC)$, in the latter case being determined indirectly by a circuit analysis based on the electric model of the accumulator starting from the function $I_{acc}(SOC)$, the function $V_g(I_g)$ and the values of the parameters of the branches of the primary reactions, whose function $f_{si}(SOC)$ coincides with $f_{pi}(SOC)$.

In some cases, as for the lead acid batteries, the functions $f_{pi}(SOC)$ can be linear.

For example, the function $f_{pi}(SOC)$ for the open-circuit voltage $V_{OC}$ can be expressed as follows:

$$f_{pi}(SOC) = f_{si}(SOC) = m_V SOC + q_V, \qquad (8)$$

wherein $m_V$ and $q_V$ are real constant-values coefficients that are determined by integration of the values of $V_{OC}$ as measured during the step of characterisation of the primary reactions. As shown by (8), $f_{si}(SOC)$ coincides with $f_{pi}(SOC)$ because the trend of the open-circuit voltage as a function of the state of charge is not influenced by the presence of the secondary reactions.

Instead, for the resistors of the model, the functions $f_{pi}(SOC)$ can be expressed as follows :

$$f_{pi} = \alpha m_{Ri0}(SOC - SOC_i) + R_{i0}, \qquad (9)$$

wherein $SOC_i$ is the initial state of charge of the charging process, $m_{Ri0}$ and $R_{i0}$ are real-values constant coefficients determined by interpolation of the resistors values determined in the step of characterisation of the primary reactions,

and $\alpha = \dfrac{1}{m_{Ri0}} \dfrac{f_{si}(SOC(t_g)) - R_{i0}}{SOC(t_g) - SOC_i}$ is a coefficient that can be determined each time for the particular charging process at hand on the basis of:

- the value of the initial state of charge $SOC_i$;
- the value of the state of charge $SOC(t_g)$ at the time instant at which the secondary reaction activates, determined by circuit simulation as the instant at which the current $I_{acc}$ equates the current $I_B$ flowing in the terminals of the accumulator,

- the value of the function $f_{si}(SOC(t_g))$, determined by circuit simulation in correspondence of the value of state of charge $SOC(t_g)$ at the instant $t_g$.

From a practical point of view, the coefficient $\alpha$ expresses a physical phenomenon by which the resistive components of the model of the lead acid batteries tend to show the same resistor value $R_{i0}$ at the beginning of the charging, irrespective of the initial state of charge $SOC_i$, and tend to increase linearly with a slope coefficient each time different depending on the current $I_B$ flowing in the accumulator and $SOC_i$, such that the resistor value at the activation of the secondary reactions is equal to that calculated on the basis of the function $f_{si}$ evaluated in correspondence of $SOC(t_g)$.

Typically, the parameters of the accumulator show also a certain dependency on the working temperature. Therefore, according to another aspect of the present invention, one can perform the different steps of the above discussed method in correspondence of a determined number of different values of the system working temperature T (such measurements can be carried out within an only charging process, or possibly in a plurality of distinct charging processes). By interpolation of the measured values of the electric parameters of the branches of the primary and secondary reactions, one can therefore calculate the different above discussed functions in such a way to determine the different parameters of the model with varying state of charge and temperature.

The proposed characterisation method can be implemented by a dedicated charging system, which is another subject matter of the present invention. The charging system at hand is provided with an input section and an output section and is able to take out the energy from a source by the input section and give it to the accumulator by the output section. To the end of realising the above discussed characterisation methods, the charging system has to comprise the following elements:

- a power section, suitable to supply electric energy to the accumulator and to apply to the same accumulator a predetermined voltage and/or current waveform;
- a measurement device for measuring the voltage at the terminals of the accumulator;
- a measurement device for measuring the current flowing in the terminals of the accumulator;
- a memory device;
- a calculation device.

According to another aspect of the present invention, the proposed method can be realised by a control system to be used in addition to a conventional battery charger. Such a control system is based on the idea that it is possible to apply to the accumulator particular voltage and/or current waveforms during a standard charging process by absorbing a given portion of the current supplied by the battery charger.

To the end of realising the proposed method, the proposed charging control system is therefore characterised by two control terminals suitable to be connected, directly or by means of one or more devices in series, to the two terminals of the output section of the battery charger, and by the presence of:

- a load device that is able to absorb electric current by the above mentioned control terminals to the end of applying to the accumulator the current and/or voltage waveforms provided by the method;
- a measurement device for measuring the voltage at the terminals of the accumulator;
- a memory device;
- a calculation device.

In another possible implementation, the described charging control system can also comprise at least a switching block connected in series between the terminals of the output section of the battery charger and the terminals of the accumulator, to the end of electrically disconnecting the accumulator and the battery charger during the time intervals wherein the load device absorbs current, and connecting them electrically in the remaining time intervals.

In some particular situations, it can also be necessary to guarantee that the charging control system is able to impose a predetermined voltage value between its control terminals. In such cases, one can resort to a further implementation of the charging control system that provides for the presence of the following elements as well:

- a voltage generator device that is able to establish an electric potential difference between its two terminals, suitable to be electrically connected, directly or by means of one or more devices in series, to the terminals of the output section of the battery charger;
- at least a switching block connected in series between the terminals of the voltage generator and the terminals of the output section of the battery charger, such switching block being configured in such a way to connect electrically the voltage generator and the battery charger during the time intervals wherein the load device absorbs current, and to disconnect them electrically in the remaining time intervals.

**EP 2 746 797 B1**

Finally, in another possible implementation, the proposed charging control system can further comprise a power section that is able to supply current by means of the control terminals of the same system.

**Bibliography**

[1] Notten et al., "Battery management system and battery simulator", patent US0060160479.

[2] Lin et al. "Adaptative battery parameter extraction and SOC estimation for lithium-ion battery", patent US2011/0309838.

[3] Denning, "Battery gas gauge", patent US7095211.

[4] Paryani, "Determining Battery DC Impedance", patent US 2011/0077879.

[5] Satake et al., "Battery capacity measurement apparatus taking into consideration a gassing voltage that changes relative to temperature", patent US6198254.

[6] Satake et al. "Battery charge control device having function to decide gassing without temperature sensor", patent US6246216.

[7] Kwok, "Method of calculating dynamic state-of-charge within a battery, patent US6300763.

[8] Berman et al., "System for improving charge efficiency of a zinc-chloride battery", patent US4001036A.

[9] Horn et al., "Process for charging maintenance-free lead batteries with a fixed electrolyte", patent 4,952,861.

[10] Ceraolo, "New Dynamical Models of Lead-Acid Batteries", IEEE Transactions on Power Systems, Vol. 15, NO. 4, 2000.

[11] Itabashi et al., "Battery model identification method", patent EP2375487.

In the foregoing, embodiments have been described and variations of the present invention have been suggested, but it is to be understood that those skilled in the art will be able to make changes and modifications without thereby falling outside the relevant scope of protection, as defined by the enclose claims.

**Claims**

1. Method for the characterisation of electric parameters of the equivalent circuit of an accumulator as a function of its state of charge, the accumulator presenting two terminals, comprising a step A.1 of identification of the equivalent electric model of the accumulator, a step A.2 of characterisation of the primary chemical reactions of the accumulator, i.e. reactions which produce charge accumulation at the terminals of the accumulator, a step A.3 of characterisation of the secondary chemical reactions of the accumulator, i.e. reactions that do not produce charge accumulation at the terminals of the accumulator, and a step A.4 of calculation of the electric parameters, **characterised in** said steps being as follows:

   A.1) defining an equivalent electric circuit **characterised by** a set of electric parameters, such a circuit comprising at least a primary branch including elements that during a charging process are traversed by current even in the presence of the only primary chemical reactions of the accumulator and to which respective primary parameters $P_i$ are associated, with i positive integer, and at least a secondary branch including elements that during a charging process are traversed by current only in the presence of secondary chemical reactions of the accumulator and to which respective secondary parameters are associated;

   A.2) characterising the primary parameters $P_i$ of the primary branch, by repetitively executing, during an initial step of at least an accumulator charging process wherein the secondary reactions are negligible, whenever the accumulator state of charge comes out to be incremented of a pre-determined quantity obtained by a measurement of the state of charge during the whole accumulator charging process, the following sub-steps:

   A.2.1) applying to the accumulator a pre-determined current and/or voltage waveform;
   A.2.2) measuring, during a time interval, a pre-determined number of voltage values at the terminals of the accumulator and/or values of current flowing into the accumulator;
   A.2.3) interpolating said voltage and/or current values measured in step A.2.2, determining an interpolating function which reconstructs the time response of the voltage or current on the accumulator as a consequence of application of said waveform, and from said function obtaining the values of the electrical parameters of said at least a primary branch;
   thus obtaining a set of values for each primary parameter $P_i$, and executing subsequently the following sub-step:

A.2.4) for each primary parameter $P_i$ of said at least a primary branch, determining, by interpolation of said set of values, a function linking the value of the parameter to the generic increment of state of charge during the charging process when only the primary reactions are active;

A.3) characterising the parameters of the at least a secondary branch, by repetitively executing, during time instants subsequent to said initial step of at least an accumulator charging process, the following subsequent steps:

A.3.1) a testing step for testing the presence of secondary reactions wherein, in a given instant, one measures the voltage and current at the accumulator terminals, and one determines the presence of secondary reactions if said voltage and current values deviate of a pre-determined quantity from the voltage and current values as calculated by means of the equivalent circuit as defined in step A.1, assuming that the current absorbed in the at least a secondary branch vanishes and determining the parameters of the at least a primary branch by extrapolating the functions determined in step A.2.4, and one memorises: first time instant $t_g$ wherein the presence of secondary reaction is determined, current $I_B(t_g)$ measured at the accumulator terminals at instant $t_g$ and the increment of state of charge $\Delta SOC(t_g)$ obtained from the beginning of the charging process till time instant $t_g$ as comes out from the state of charge measurements of step A.2;

A.3.2) a sampling step wherein one memorises a pre-determined number of voltage and current values at the accumulator terminals in correspondence of time instants subsequent to said time instant $t_g$;

A.4) determining, in any time instant subsequent to the end of said step A.3, mathematical functions allowing to calculate, for a hypothetical charging process, the primary electrical parameters $P_i$ of the accumulator in correspondence of any value of the state of charge both in the absence and in the presence of secondary reactions, carrying out the following sub-steps:

A.4.1) determining, on the basis of a value of the initial state of charge $SOC_0$ of said at least a charging process and the values of $t_g$, $I_B(t_g)$ and $\Delta SOC(t_g)$ stored in step A.3.1, a function $I_{acc}(SOC)$, linking the maximum current $I_{acc}$ that can be absorbed by the at least a primary branch and the state of charge $SOC$, that satisfies the condition:

$$I_{acc}\left[SOC_0 + \Delta SOC\left(t_g\right)\right] = I_B\left(t_g\right)$$

A.4.2) determining, on the basis of the function $I_{acc}(SOC)$ and the accumulator equivalent circuit, the values of the voltage and current at the terminals of the at least a secondary branch in correspondence of the values of voltage and current at the terminals of the accumulator stored in step A.3.2, and, by interpolating such values, determining a function $V_g(I_g)$ expressing the relationship between voltage $V_g$ and current $I_g$ at the terminals of the at least a secondary branch;

A.4.3) determining mathematical functions connecting primary parameters $P_i$ and the state of charge both in the absence and in the presence of secondary reactions, carrying out for each primary parameter $P_i$ the following sub-steps:

A.4.3.1) determining, by interpolation of the values of said set of values of the parameters referred of step A.2, an interpolating function $f_{pi}(SOC)$, expressing the relationship between the primary parameter $P_i$ and the state of charge when only the primary reactions are active, and

A.4.3.2) determining a function $f_{si}(SOC)$ expressing the relationship between the primary parameter $P_i$ and the state of charge when also the secondary reactions are active, such a function coinciding with $f_{pi}(SOC)$ if the value of the primary parameter $P_i$ as a function of $SOC$ is not influenced by the presence of secondary reactions, otherwise it being determined by circuit analysis on the basis of the accumulator equivalent electric circuit as defined in step A.1, the function $I_{acc}(SOC)$, the function $V_g(I_g)$ and the parameters whose function $f_{si}(SOC)$ coincides with $f_{pi}(SOC)$.

2.  Method according to claim 1, wherein the initial state of charge $SOC_0$ is not known before said at least a charging process, and in place of step A.4.1 the following step is executed:

A.4.1bis) determining the initial state of charge $SOC_0$ of said at least a charging process and a mathematical function $I_{acc}(SOC)$ connecting the maximum current $I_{acc}$ that can be absorbed by the at least a primary branch and the state of charge $SOC$, carrying out the iterative procedure consisting of the following steps:

A.4.1.1) assuming a value of $SOC_0$;

A.4.1.2) on the basis of the assumed value of $SOC_0$ and the values of $t_g$, $I_B(t_g)$ and $\Delta SOC(t_g)$ stored in step A.3.1, calculating a function $I_{acc}(SOC)$ satisfying the condition:

$$I_{acc}\left[ SOC_0 + \Delta SOC\left(t_g\right)\right] = I_B\left(t_g\right)$$

A.4.1.3) calculating the state of charge increment $\Delta SOC_S$ obtained by integrating the current $I_{acc}$, calculated according to the function determined in step A.4.1.2, from instant $t_g$ till a pre-determined instant of said at least a charging process of steps A.2 and A.3, and calculating the state of charge $SOC_f$ of the charging process in said pre-determined instant, estimated on the basis of the following relationship:

$$SOC_f = SOC_0 + \Delta SOC\left(t_g\right) + \Delta SOC_S$$

A.4.1.4) calculating the difference between the state of charge actually achieved in said pre-determined instant of said at least a charging process and the state of charge $SOC_f$ estimated in step A.4.1.3;

A.4.1.5) if the difference calculated in step A.4.1.4 exceeds a pre-determined quantity, increasing the assumed value of $SOC_0$ by a quantity that is function of said difference, in particular proportional to said difference, and repeating steps A.4.1.2-A.4.1.5, otherwise terminating the iterative procedure.

3. Method according to claim 1 or 2, wherein for a pre-determined number of repetitions of step A.2.2 one performs a first group of measurements wherein:

- the duration of the time interval wherein each measurement is carried out is such to allow the measurement of all the parameters of said at least a primary branch, and wherein the measured parameters values are also utilised to define mathematical functions expressing a subset of the parameters of said at least a primary branch as a function of a different subset of the parameters of said at least a primary branch assumed as set of reference parameters;

and wherein the remaining repetitions of step A.2.2 comprise a second group of measurements, wherein:

- the duration of the time interval is such to allow only the measurement of said reference parameters, and wherein the values of the remaining parameters of said at least a primary branch are obtained from the values of said reference parameters by extrapolation using the functions calculated during the first group of measurements.

4. Method according to any claim 1 to 3, wherein function $I_{acc}(SOC)$ is:

$$I_{acc} = \frac{A_0}{1 - SOC_i}\left(\frac{1}{SOC} - 1\right),$$

$SOC_i$ being the initial state of charge of said hypothetical charging process, and $A_0$ being a real value constant coefficient, determined in step A.4.1 according to claim 1, or in step A.4.1bis in the method according to claim 2.

5. Method according to any claim 1 to 4, wherein function $V_g(I_g)$ determined in step A.4.2 is:

$$V_g = V_{g0} + a_1 \frac{I_{Bref}}{I_B} I_g + a_2 \left(\frac{I_{Bref}}{I_B}\right)^2 I_g^{\;2},$$

during the time intervals of the process wherein the charging process is at constant current, i.e. wherein the charging system connected to the accumulator behaves as a current generator, $I_{Bref}$ being a generic value of the current flowing through the accumulator terminals that is taken as a reference value, $V_{g0}$, $a_1$ and $a_2$ being real value constant coefficients determined by interpolation of at least three values of $I_g$ and $V_g$ obtained in step A.4.2, and instead function $V_g(I_g)$ is of the type

$$V_g = \frac{I_g - q_g}{m_g},$$

during the time intervals of the process wherein the charging process is at constant voltage, i.e. wherein the charging system connected to the accumulator behaves as a voltage generator, $q_g$ and $m_g$ being two real-value coefficients whose value takes into account the voltage applied to the accumulator during the specific time interval wherein the charging process is at constant voltage.

6.  Method according to any claim 1 to 5, wherein the at least a primary branch of the accumulator equivalent circuit defined in step A.1 comprises a determined number of resistors and at least a voltage generator whose value $V_{OC}$ models the open-circuit voltage of the accumulator.

7.  Method according to claim 6, wherein, for each resistor belonging to the at least a primary branch of the accumulator equivalent circuit, the function $f_{pi}(SOC)$ determined in step A.4.3.1 is:

$$f_{pi} = \alpha m_{Ri0}\left(SOC - SOC_i\right) + R_{i0},$$

$SOC_i$ being the initial state of charge of said hypothetical charging process, $m_{Ri0}$ and $R_{i0}$ being real-value constant coefficients determined by means of interpolation of at least two values of said resistor as measured in step A.2, and $\alpha$ being a coefficient whose value is determined each time for each charging process according to the relationship:

$$\alpha = \frac{1}{m_{Ri0}} \frac{f_{si}\left(SOC\left(t_g\right)\right) - R_{i0}}{SOC\left(t_g\right) - SOC_i},$$

wherein $t_g$ is the instant at which the secondary reactions start, determined as the instant at which the current $I_{acc}$ equals the current $I_B$ flowing through the accumulator terminals, $SOC(t_g)$ is the value of the state of charge calculated at $t_g$, and $f_{si}(SOC(t_g))$ is the value of the function $f_{si}(SOC)$, as determined in step A.4.3.2, calculated in correspondence of said value of $SOC(t_g)$.

8.  Method according to any claim 6 and 7, wherein function $f_{pi}(SOC)$ as determined in step A.4.3.1 and function $f_{si}(SOC)$ as determined in step A.4.3.2 for the voltage generator of value $V_{OC}$ coincide and are of the type:

$$f_{pi}(SOC) = f_{si}(SOC) = m_V SOC + q_V,$$

$m_v$ and $q_v$ being real-value constant coefficients determined by interpolation of at least two values of $V_{OC}$ determined in step A.2.

9.  Method according to any claim 1 to 8, wherein steps A.2 and A.3 are carried-out in correspondence to a given number of accumulator working temperature T to the end of characterising the parameters of the accumulator equivalent circuit even as a function of the working temperature, determining in step A.4, by interpolation of the measured values:

- a function $I_{acc}(SOC, T)$ expressing the relationship between the maximum current that can be absorbed by the at least a primary branch and any values pair (SOC,T), and a function $V_g(I_g, T)$ expressing the relationship between the voltage at the terminals of the at least a secondary branch and any values pair ($I_g$, T),

and, for each parameter of the at least a primary branch, determining:

- a function $f_{pi}(SOC, T)$, each time different depending on the parameter $P_i$, that expresses the relationship between the parameter and any values pair (SOC,T) when only the primary reactions are active, and a function $f_{si}(SOC,T)$, each time different depending on the parameter $P_i$, expressing the relationship between the parameter and any values pair (SOC,T) when also the secondary reactions are active, such a function $f_{si}(SOC,T)$ coinciding with $f_{pi}(SOC,T)$ if the value of the parameter as a function of (SOC,T) is not influenced by the presence of secondary reactions, otherwise being determined by circuit analysis on the basis of the accumulator equivalent circuit, the functions $I_{acc}(SOC,T)$, $V_g(I_g, T)$ and the parameters whose function $f_{si}(SOC,T)$ coincides with $f_{pi}(SOC,T)$.

10. Charging system for electric energy accumulators, such a system being provided with an input section and an output section and is able to take energy from a source by the input section and to give energy to the accumulator by the output section, the system comprising the following elements:

- a power section, suitable to provide electric energy to the accumulator and to apply to the same accumulator pre-determined voltage and/or current waveforms,
- a voltage measurement device for measuring voltage at the terminals of the accumulator,
- a current measurement device for measuring current flowing into the terminals of the accumulator,
- a memory device, and
- an electronic calculation device,

said system being suitable to perform any charging process of the accumulator and the method of characterisation of the electric parameters of the electric equivalent circuit according to any claim 1 to 9, wherein:

- said power section is configured to apply to the accumulator a current and/or voltage waveform according to step A.2.1 ;
- said voltage measurement device and said current measurement device are configured to perform the measurements of steps A.2.2, A.3.1, A.3.2;
- said calculation device perform the calculations of steps A.2, A.3 and A.4;
- said memory device is used to store the data calculated by the method.

11. Charge control system for an electric energy accumulator receiving energy from an external battery charger, which includes an input section and an output section and is able to take energy from a source by the input section and to give energy to the accumulator by the output section having two terminals, said charge control system being **characterized in that** it comprises two control terminals suitable to be connected, directly or by means of one or more devices in series, at the two terminals of said output section of the battery charger, and **in that** it further comprises:

- a load device suitable to absorb electric current by said two control terminals;
- a voltage measurement device for measuring the voltage at the terminals of the accumulator;
- a current measurement device for measuring the current flowing into the accumulator terminals,
- a memory device, and
- a calculation device,

said system being suitable to execute the method of characterization of the electrical parameters of the accumulator electric equivalent circuit according to any claim 1 to 9, wherein:

- said load device is configured to absorb electric current by said two control terminals during pre-defined time intervals in such a way that a pre-defined current and/or voltage waveform is applied to the accumulator, according to step A.2.1;
- said voltage measurement device and said current measurement device are configured to perform the measurements of steps A.2.2, A.3.1, A.3.2;
- said calculation device performs the calculations of steps A.2, A.3 and A.4;
- said memory device is configured to store the data calculated in the method.

12. Charge control system according to claim 11, further comprising at least a switching block connected in series between the terminals of the output section of the battery charger and the accumulator terminals, such a switching block being configured in such a way to electrically disconnect the accumulator from the output section of the battery charger during the time intervals wherein the load device absorb current, and to electrically connect the accumulator to the output section of the battery charger in the remaining time intervals, said system further comprising the following elements:

- a voltage generator provided with two terminals suitable to be electrically connected, directly or by one or more devices in series, to the terminals of the output section of the battery charger, said voltage generator being suitable to establish a voltage difference between its terminals;
- at least a switching block connected in series between the terminals of said voltage generator and the terminals of the output section of the battery charger, such switching block being configured in such a way to electrically connect the voltage generator to the output section of the battery charger during the time intervals wherein the load device absorbs current, and to electrically disconnect the voltage generator from the output section of the battery charger in the remaining time intervals.

13. Charge control system according to any claim 11 to 12, **characterised in that** it further comprises a power section suitable to supply current by said two control terminals.

14. Computer program, **characterised in that** it comprises code means configured in such a way that, when they are executed by a computer, perform the calculations of steps A.2, A.3 and A.4 of the method according to any claim 1 to 9.

15. Memory support, **characterised in that** it has stored on itself the program according to claim 14.


**Patentansprüche**

1. Verfahren zur Charakterisierung elektrischer Parameter der Ersatzschaltung eines Akkumulators in Abhängigkeit seines Ladungszustandes, wobei der Akkumulator über zwei Anschlüsse verfügt, wobei das Verfahren folgende Schritte aufweist:
einen Schritt A.1 einer Identifizierung des äquivalenten elektrischen Modells des Akkumulators, einen Schritt A.2 einer Charakterisierung der primären chemischen Reaktionen des Akkumulators, d. h. Reaktionen, die eine Ladungsakkumulation an den Anschlüssen des Akkumulators erzeugen, einen Schritt A.3 einer Charakterisierung der sekundären chemischen Reaktionen des Akkumulators, d. h. Reaktionen, die keine Ladungsakkumulation an den Anschlüssen des Akkumulators erzeugen, und einen Schritt A.4 einer Berechnung der elektrischen Parameter, **dadurch gekennzeichnet, dass** die Schritte wie folgt sind:

A.1) Definieren einer Ersatzschaltung, die durch einen Satz elektrischer Parameter charakterisiert ist, wobei eine solche Schaltung zumindest eine primäre Verzweigung, die Elemente umfasst, die während eines Ladungsprozesses sogar nur bei Vorhandensein der primären chemischen Reaktionen des Akkumulators von einem Strom durchlaufen werden und denen jeweilige primäre Parameter $P_i$ zugeordnet sind, wobei i eine positive Ganzzahl ist, und zumindest eine sekundäre Verzweigung aufweist, die Elemente umfasst, die während eines Ladungsprozesses nur bei Vorhandensein von sekundären chemischen Reaktionen des Akkumulators von einem Strom durchlaufen werden und denen jeweilige sekundäre Parameter zugeordnet sind;
A.2) Charakterisieren der primären Parameter $P_i$ der primären Verzweigung durch wiederholtes Ausführen der folgenden Teilschritte während eines anfänglichen Schrittes zumindest eines Akkumulatorladungsprozesses, wobei die sekundären Reaktionen vernachlässigbar sind, wenn hervorgeht, dass der Akkumulatorladungszustand um eine vorbestimmte Größe erhöht wird, die durch eine Messung des Ladungszustands während des gesamten Akkumulatorladungsvorgangs erhalten wird:

A.2.1) Anlegen eine vorbestimmten Strom- und/oder einer Spannungswellenform an den Akkumulator;
A.2.2) Messen einer vorbestimmten Anzahl von Spannungswerten an den Anschlüssen des Akkumulators und/oder von Werten eines in den Akkumulator fließenden Stromes während eines Zeitintervalls;
A.2.3) Interpolieren der in Schritt A.2.2 gemessenen Spannungs- und/oder Stromwerte, Bestimmen einer Interpolationsfunktion, die das Zeitverhalten der Spannung oder des Stromes an dem Akkumulator als Folge des Anlegens der Wellenform rekonstruiert, und Erhalten der Werte der elektrischen Parameter der zumindest einen primären Verzweigung aus der Funktion;
wobei somit ein Satz von Werten für jeden primären Parameter $P_i$ erhalten wird und anschließend der folgende Teilschritt ausgeführt wird:
A.2.4) für jeden primären Parameter $P_i$ der zumindest einen primären Verzweigung, Bestimmen einer Funktion, die durch eine Interpolation des Satzes von Werten den Wert des Parameters mit dem generischen Ladungszustandsinkrement während des Ladungsprozesses verknüpft, wenn lediglich die primären Reaktionen aktiv sind;

A.3) Charakterisieren der Parameter der zumindest einen zweiten Verzweigung durch wiederholtes Ausführen der anschließenden Schritte während Zeitpunkten nach dem anfänglichen Schritt zumindest eines Akkumulatorladungsprozesses:

A.3.1) einen Überprüfungsschritt zum Überprüfen des Vorhandenseins der sekundären Reaktionen, wobei zu einem gegebenen Zeitpunkt die Spannung und der Strom an den Akkumulatoranschlüssen gemessen werden und das Vorhandensein sekundärer Reaktionen bestimmt wird, wenn die Spannungs- und Stromwerte um eine vorbestimmte Größe von den Spannungs- und Stromwerten, die mithilfe der in Schritt A.1 definierten Ersatzschaltung berechnet werde, abweichen, wobei davon ausgegangen wird, dass der in der zumindest einen sekundären Verzweigung absorbierte Strom verschwindet, und wobei die Parameter der zumindest einen primären Verzweigung durch Extrapolieren der in Schritt A.2.4 bestimmten Funktionen bestimmt werden, und Folgendes gespeichert wird: zuerst Zeitpunkt $t_g$, an dem das Vorhandensein der sekundären Reaktion bestimmt wird, Strom $I_B(t_g)$, der an dem Akkumulatoranschlüssen zum Zeitpunkt $t_g$ gemessen wird, und das Ladungszustandsinkrement $\Delta SOC(t_g)$, das vom Beginn des Ladungsprozesses bis zum Zeitpunkt $t_g$ erhalten wird, der aus den Ladungszustandsmessungen aus Schritt A.2 hervorgeht;

A.3.2) einen Abtastschritt, bei dem eine vorbestimmte Anzahl an Spannungs- und Stromwerten an den Akkumulatoranschlüssen in Übereinstimmung mit Zeitpunkten nach dem Zeitpunkt $t_g$ gespeichert werden;

A.4) Bestimmen, zu jeglichem Zeitpunkt nach dem Ende des Schrittes A.3, mathematischer Funktionen, die es ermöglichen, für einen hypothetischen Ladungsprozess die primären elektrischen Parameter $P_i$ des Akkumulators in Übereinstimmung mit einem beliebigen Wert des Ladungszustandes sowohl in Abwesenheit als auch bei Vorhandensein sekundärer Reaktionen zu berechnen, wobei die folgenden Teilschritte ausgeführt werden:

A.4.1) Bestimmen, auf der Basis eines Wertes des anfänglichen Ladungszustandes SOCo des zumindest einen Ladungsprozesses und der in Schritt A.3.1 gespeicherten Werte von $t_g$, $I_B(t_g)$ und $\Delta SOC(t_g)$, einer Funktion $I_{acc}(SOC)$, die den maximalen Strom $I_{acc}$, der von der zumindest einen primären Verzweigung absorbiert werden kann, und den Ladungszustand SOC verknüpft, welche folgende Bedingung erfüllt:

$$I_{acc}\left[ SOC_0 + \Delta SOC\left(t_g\right) \right] = I_B\left(t_g\right)$$

A.4.2) Bestimmen, auf der Basis der Funktion $I_{acc}(SOC)$ und der Akkumulatorersatzschaltung, der Werte der Spannung und des Stromes an den Anschlüssen der zumindest einen sekundären Verzweigung in Übereinstimmung mit den in Schritt A.3.2 gespeicherten Werten der Spannung und des Stromes an den Anschlüssen des Akkumulators, und, durch Interpolieren solcher Werte, Bestimmen einer Funktion $V_g(I_g)$, die die Beziehung zwischen Spannung $V_g$ und Strom $I_g$ an den Anschlüssen der zumindest einen sekundären Verzweigung ausdrückt;

A.4.3) Bestimmen mathematischer Funktionen, die primäre Parameter $P_i$ und den Ladungszustand sowohl in Abwesenheit als auch bei Vorhandensein der sekundären Reaktionen verbinden, wobei für jeden primären Parameter $P_i$ die folgenden Teilschritte ausgeführt werden:

A.4.3.1) Bestimmen, durch Interpolation der Werte des in Schritt A.2 genannten Satzes von Werten der Parameter, einer interpolierenden Funktion $f_{pi}(SOC)$, welche die Beziehung zwischen dem primären Parameter $P_i$ und dem Ladungszustand ausdrückt, wenn lediglich die primären Reaktionen aktiv sind, und

A.4.3.2) Bestimmen einer Funktion $f_{si}(SOC)$, die die Beziehung zwischen dem primären Parameter $P_i$ und dem Ladungszustand ausdrückt, wenn auch die sekundären Reaktionen aktiv sind, wobei eine solche Funktion mit $f_{pi}(SOC)$ übereinstimmt, wenn der Wert des primären Parameters $P_i$ in Abhängigkeit von SOC nicht durch das Vorhandensein von sekundären Reaktionen beeinflusst wird, wobei sie andernfalls durch eine Schaltungsanalyse auf der Basis der in Schritt A.1 definierten Akkumulatorersatzschaltung, der Funktion $I_{acc}(SOC)$, der Funktion $V_g(I_g)$ und der Parameter bestimmt wird, deren Funktion $f_{si}(SOC)$ mit $f_{pi}(SOC)$ übereinstimmt.

**2.** Verfahren gemäß Anspruch 1, bei dem der anfängliche Ladungszustand $SOC_0$ vor dem zumindest einen Ladungsprozess nicht bekannt ist, und anstelle von Schritt A.4.1 der folgende Schritt ausgeführt wird:

A.4.1bis) Bestimmen des anfänglichen Ladungszustandes $SOC_0$ des zumindest einen Ladungsprozesses und einer mathematischen Funktion $I_{acc}(SOC)$, die den maximalen Strom $I_{acc}$, der durch die zumindest eine primäre Verzweigung absorbiert werden kann, und den Ladungszustand SOC verbindet, wobei der iterative Prozess aus den folgenden Schritten ausgeführt wird:

A.4.1.1) Annehmen eines Wertes von $SOC_0$;

A.4.1.2) Berechnen einer Funktion $I_{acc}(SOC)$ auf der Basis des angenommenen Wertes von $SOC_0$ und der in Schritt A.3.1 gespeicherten Werte von $t_g$, $I_B(t_g)$ und $\Delta SOC(t_g)$, die folgende Bedingung erfüllt:

$$I_{acc}\left[SOC_0 + \Delta SOC\left(t_g\right)\right] = I_B\left(t_g\right)$$

A.4.1.3) Berechnen des Ladungszustandsinkrements $\Delta SOC_S$, das dadurch erhalten wird, dass der gemäß der in Schritt A.4.1.2 bestimmten Funktion berechnete Stromes $I_{acc}$ von dem Zeitpunkt $t_g$ bis zu einem vorbestimmten Zeitpunkt des zumindest einen Ladungsprozesses aus Schritten A.2 und A.3 integriert wird, und Berechnen des Ladungszustandes SOCf des Ladungsprozesses zu dem vorbestimmten Zeitpunkt, der auf der Basis der folgenden Beziehung geschätzt wird:

$$SOC_f = SOC_0 + \Delta SOC\left(t_g\right) + \Delta SOC_S$$

A.4.1.4) Berechnen der Differenz zwischen dem zu dem vorbestimmten Zeitpunkt des zumindest einen Ladungsprozesses tatsächlich erreichten Ladungszustand und dem in Schritt A.4.1.3 geschätzten Ladungszustand $SOC_f$;

A.4.1.5) falls die in Schritt A.4.1.4 berechnete Differenz eine vorbestimmte Größe überschreitet, Erhöhen des angenommenen Wertes von $SOC_0$ um eine Größe, die abhängig von der Differenz ist, im Einzelnen proportional zu der Differenz, und Wiederholen der Schritte A.4.1.2 - A.4.1.5, wobei der iterative Prozess ansonsten beendet wird.

**3.** Verfahren gemäß Anspruch 1 oder 2, bei dem für eine vorbestimmte Anzahl von Wiederholungen von Schritt A.2.2 eine erste Gruppe von Messungen ausgeführt wird, wobei

- die Dauer des Zeitintervalls, in dem jede Messung ausgeführt ist, derart ist, die Messung aller Parameter der zumindest einen primären Verzweigung zu ermöglichen, und wobei die gemessenen Parameterwerte auch dazu verwendet werden, mathematische Funktionen zu definieren, die einen Teilsatz der Parameter der zumindest einen primären Verzweigung in Abhängigkeit eines unterschiedlichen Teilsatzes der Parameter der zumindest einen primären Verzweigung ausdrücken, die als Satz von Referenzparametern angenommen werden;
- und wobei die verbleibenden Wiederholungen von Schritt A.2.2 eine zweite Gruppe von Messungen aufweisen, wobei:
- die Dauer des Zeitintervalls derart ist, lediglich die Messung der Referenzparameter zu ermöglichen, und wobei die Werte der verbleibenden Parameter der zumindest einen primären Verzweigung aus den Werten der Referenzparameter durch Extrapolation unter Verwendung der während der ersten Gruppe von Messungen berechneten Funktionen erhalten werden.

**4.** Verfahren gemäß einem der Ansprüche 1 bis 3, bei dem die Funktion $I_{acc}(SOC)$ wie folgt lautet:

$$I_{acc} = \frac{A_0}{1 - SOC_i}\left(\frac{1}{SOC} - 1\right),$$

wobei $SOC_i$ ein anfänglicher Ladungszustand des hypothetischen Ladungsprozesses ist und wobei $A_0$ ein realwertiger konstanter Koeffizient ist, der in Schritt A.4.1 gemäß Anspruch 1 oder in Schritt A.4.1 bis in dem Verfahren gemäß Anspruch 2 bestimmt wird.

5. Verfahren gemäß einem der Ansprüche 1 bis 4, bei dem die in Schritt A.4.2 bestimmte Funktion $V_g(I_g)$ während der Zeitintervalle des Prozesses, in denen der Ladungsprozess einen konstanten Strom aufweist, d. h., in denen sich das mit dem Akkumulator verbundene Ladungssystem als Stromgenerator verhält, wie folgt lautet:

$$V_g = V_{g0} + a_1 \frac{I_{Bref}}{I_B} I_g + a_2 \left( \frac{I_{Bref}}{I_B} \right)^2 I_g^{\,2} \,,$$

wobei $I_{Bref}$ ein generischer Wert des Stromes ist, der durch die Akkumulatoranschlüsse fließt, der als Referenzwert genommen wird, wobei $V_{g0}$, $a_1$ und $a_2$ realwertige konstante Koeffizienten sind, die durch Interpolation von zumindest drei in Schritt A.4.2 erhaltenen Werten von $I_g$ und $V_g$ bestimmt werden,
und andererseits ist die Funktion $V_g(I_g)$ während der Zeitintervalle des Prozesses, in denen der Ladungsprozess eine konstante Spannung aufweist, d. h., in denen sich das mit dem Akkumulator verbundene Ladungssystem als Spannungsgenerator verhält, vom folgenden Typ:

$$V_g = \frac{I_g - q_g}{m_g} \,,$$

wobei $q_g$ und $m_g$ zwei realwertige Koeffizienten sind, deren Wert die Spannung berücksichtigt, die an den Akkumulator während des spezifischen Zeitintervalls angelegt wird, in dem der Ladungsprozess bei einer konstanten Spannung ist.

6. Verfahren gemäß einem der Ansprüche 1 bis 5, bei dem die zumindest eine primäre Verzweigung der in Schritt A.1 definierten Akkumulatorersatzschaltung eine bestimmte Anzahl an Widerständen und zumindest einen Spannungsgenerator aufweist, dessen Wert $V_{OC}$ die Leerlaufspannung des Akkumulators modelliert.

7. Verfahren gemäß Anspruch 6, bei dem die in Schritt A.4.3.1 bestimmte Funktion $f_{pi}(SOC)$ für jeden Widerstand, der zu der zumindest einen primären Verzweigung der Akkumulatorersatzschaltung gehört, wie folgt lautet:

$$f_{pi} = \alpha m_{Ri0} \left( SOC - SOC_i \right) + R_{i0} \,,$$

wobei $SOC_i$ der anfängliche Ladungszustand des hypothetischen Ladungsprozesses ist, $m_{Ri0}$ und $R_{i0}$ realwertige konstante Koeffizienten sind, die durch Interpolation von zumindest zwei Werten des Widerstandes, gemessen in Schritt A.2, bestimmt werden, und $\alpha$ ein Koeffizient ist, dessen Wert jedes Mal für jeden Ladungsprozess gemäß folgender Beziehung bestimmt wird:

$$\alpha = \frac{1}{m_{Ri0}} \frac{f_{si}\left( SOC\left( t_g \right) \right) - R_{i0}}{SOC\left( t_g \right) - SOC_i} \,,$$

wobei $t_g$ der Zeitpunkt ist, zu dem die sekundären Reaktionen beginnen, welcher als der Zeitpunkt bestimmt ist, zu dem der Strom $I_{acc}$ dem durch die Akkumulatoranschlüsse fließenden Strom $I_B$ gleicht, wobei $SOC(t_g)$ der Wert des Ladungszustandes berechnet zu $t_g$ ist und $f_{si}(SOC(t_g))$ der in Übereinstimmung mit dem Wert von $SOC(t_g)$ berechnete Wert der in Schritt A.4.3.2 bestimmten Funktion $f_{si}(SOC)$ ist.

8. Verfahren gemäß einem der Ansprüche 6 und 7, wobei die in Schritt A.4.3.1 bestimmte Funktion $f_{pi}(SOC)$ und die in Schritt A.4.3.2 bestimmte Funktion $f_{si}(SOC)$ für den Spannungsgenerator von Wert $V_{OC}$ übereinstimmen und vom folgenden Typ sind:

$$f_{pi}(SOC) = f_{si}(SOC) = m_V SOC + q_V \, ,$$

wobei $m_V$ und $q_V$ realwertige konstante Koeffizienten sind, die durch Interpolation von zumindest zwei in Schritt A.2 bestimmten Werten von $V_{OC}$ bestimmt werden.

**9.** Verfahren gemäß einem der Ansprüche 1 bis 8, bei dem die Schritte A.2 und A.3 in Übereinstimmung mit einer gegebenen Anzahl von Akkumulatorarbeitstemperaturen T bis zum Ende des Charakterisierens der Parameter der Akkumulatorersatzschaltung ausgeführt werden, auch in Abhängigkeit von der Arbeitstemperatur, wobei in Schritt A.4 durch Interpolation der gemessenen Werte Folgendes bestimmt wird:

- eine Funktion $I_{acc}(SOC, T)$, die die Beziehung zwischen dem maximalen Strom, der durch die zumindest eine primäre Verzweigung absorbiert werden kann, und einem beliebigen Wertepaar (SOC, T) ausdrückt, und eine Funktion $V_g(I_g, T)$, die die Beziehung zwischen dem Strom an den Anschlüssen der zumindest einen sekundären Verzweigung und einem beliebigen Wertepaar ($I_g$, T) ausdrückt,

und wobei für jeden Parameter der zumindest einen primären Verzweigung Folgendes bestimmt wird:

- eine Funktion $f_{pi}(SOC, T)$, die sich jedes Mal in Abhängigkeit von dem Parameter $P_i$ unterscheidet, welche die Beziehung zwischen dem Parameter und einem beliebigen Wertepaar (SOC, T) ausdrückt, wenn lediglich die primären Reaktionen aktiv sind, und eine Funktion $f_{si}(SOC, T)$, die sich jedes Mal in Abhängigkeit von dem Parameter $P_i$ unterscheidet, welche die Beziehung zwischen dem Parameter und einem beliebigen Wertepaar (SOC, T) ausdrückt, wenn auch die sekundären Reaktionen aktiv sind, wobei solch eine Funktion $f_{si}(SOC, T)$ mit $f_{pi}(SOC, T)$ übereinstimmt, wenn der Wert des Parameters in Abhängigkeit von (SOC, T) nicht durch das Vorhandensein von sekundären Reaktionen beeinflusst wird, wobei diese andernfalls durch eine Schaltungsanalyse auf der Basis der Akkumulatorersatzschaltung, der Funktionen $I_{acc}(SOC, T)$, $V_g(I_g, T)$ und der Parameter bestimmt werden, deren Funktion $f_{si}(SOC, T)$ mit $f_{pi}(SOC, T)$ übereinstimmen.

**10.** Ladungssystem für Elektroenergieakkumulatoren, wobei ein solches System mit einem Eingabebereich und einem Ausgabebereich versehen ist und Energie von einer Quelle durch den Eingabebereich entnehmen und Energie durch den Ausgabebereich an den Akkumulator abgeben kann, wobei das System folgende Elemente aufweist:

- einen Leistungsbereich, der dazu geeignet ist, dem Akkumulator elektrische Energie bereitzustellen und vorbestimmte Spannungs- und/oder Stromwellenformen an demselben Akkumulator anzulegen,
- eine Spannungsmessvorrichtung zum Messen einer Spannung an den Anschlüssen des Akkumulators,
- eine Strommessvorrichtung zum Messen eines in die Anschlüsse des Ackumulators fließenden Stromes,
- eine Speichervorrichtung, und
- eine elektronische Berechnungsvorrichtung,

wobei das System dazu geeignet ist, einen Ladungsprozess des Akkumulators und das Verfahren der Charakterisierung der elektrischen Parameter der Ersatzschaltung gemäß einem der Ansprüche 1 bis 9 auszuführen, wobei:

- der Leistungsbereich dazu ausgebildet ist, eine Strom- und/oder Spannungswellenform gemäß Schritt A.2.1 an den Akkumulator anzulegen;
- die Spannungsmessvorrichtung und die Strommessvorrichtung dazu ausgebildet sind, die Messungen aus den Schritten A.2.2, A.3.1, A.3.2 auszuführen;
- die Berechnungsvorrichtung dazu ausgebildet ist, die Berechnungen aus den Schritten A.2, A.3 und A.4 auszuführen;
- die Speichervorrichtung dazu verwendet wird, die durch das Verfahren berechneten Daten zu speichern.

**11.** Ladungssteuerungssystem für einen Elektroenergieakkumulator, der Energie von einer externen Batterieladungseinrichtung empfängt, welche einen Eingabebereich und einen Ausgabebereich umfasst und Energie von einer Quelle durch den Eingabebereich entnehmen und Energie durch den Ausgabebereich, der zwei Anschlüsse aufweist, an den Akkumulator abgeben kann, wobei das Ladungssteuerungssystem **dadurch gekennzeichnet ist, dass** es zwei Steuerungsanschlüsse aufweist, die dazu geeignet sind, direkt oder durch eine oder mehrere Vorrichtungen in Reihe an den zwei Anschlüssen des Ausgabebereiches der Batterieladungseinrichtung verbunden zu sein, und dadurch, dass es ferner Folgendes aufweist:

- eine Lastvorrichtung, das dazu geeignet ist, einen elektrischen Strom durch die zwei Steueranschlüsse zu absorbieren;
- eine Spannungsmessvorrichtung zum Messen der Spannung an den Anschlüssen des Akkumulators;
- eine Strommessvorrichtung zum Messen des in die Akkumulatoranschlüsse fließenden Stromes,
- eine Speichervorrichtung, und
- eine Berechnungsvorrichtung,

wobei das System dazu geeignet ist, das Verfahren der Charakterisierung der elektrischen Parameter der Akkumulatorersatzschaltung gemäß einem der Ansprüche 1 bis 9 auszuführen, wobei:

- die Lastvorrichtung dazu ausgebildet ist, während vordefinierter Zeitintervalle derart elektrischen Strom durch die zwei Steueranschlüsse zu absorbieren, dass eine vordefinierte Strom- und/oder Spannungswellenform an den Akkumulator angelegt wird, gemäß Schritt A.2.1;
- die Spannungsmessvorrichtung und die Strommessvorrichtung dazu ausgebildet sind, die Messungen aus den Schritten A.2.2, A.3.1, A.3.2 auszuführen;
- die Berechnungsvorrichtung die Berechnungen aus den Schritten A.2, A.3 und A.4 ausführt;
- die Speichervorrichtung dazu ausgebildet ist, die in dem Verfahren berechneten Daten zu speichern.

12. Spannungssteuerungssystem gemäß Anspruch 11, das ferner zumindest einen Umschaltblock aufweist, der in Reihe zwischen die Anschlüsse des Ausgabebereiches der Batterieladungseinrichtung und die Akkumulatoranschlüsse geschaltet ist, wobei solch ein Umschaltblock dazu ausgebildet ist, den Akkumulator während der Zeitintervalle elektrisch von dem Ausgabebereich der Batterieladungseinrichtung zu trennen, in denen die Lastvorrichtung einen Strom absorbiert, und den Ackumulator in den verbleibenden Zeitintervallen elektrisch mit dem Ausgabebereich der Batterieladungseinrichtung zu verbinden, wobei das System ferner die folgenden Elemente aufweist:

- einen Spannungsgenerator, der mit zwei Anschlüssen versehen ist, die dazu geeignet sind, direkt oder durch ein oder mehrere Geräte elektrisch in Reihe mit den Anschlüssen des Ausgabebereiches der Batterieladungseinrichtung verbunden zu sein, wobei der Spannungsgenerator dazu geeignet ist, eine Spannungsdifferenz zwischen seinen Anschlüssen zu erzeugen;
- zumindest einen Umschaltblock, der zwischen die Anschlüsse des Spannungsgenerators und die Anschlüsse des Ausgabebereiches der Batterieladungseinrichtung in Reihe geschaltet ist, wobei solch ein Umschaltblock dazu ausgebildet ist, den Spannungsgenerator während der Zeitintervalle elektrisch mit dem Ausgabebereich der Batterieladungseinrichtung zu verbinden, in denen die Lastvorrichtung einen Strom absorbiert, und den Spannungsgenerator in den verbleibenden Zeitintervallen elektrisch von dem Ausgabebereich der Batterieladungseinrichtung zu trennen.

13. Ladungssteuerungssystem gemäß einem der Ansprüche 11 bis 12, das **dadurch gekennzeichnet ist, dass** dasselbe ferner einen Leistungsbereich aufweist, der dazu geeignet ist, durch die zwei Steueranschlüsse einen Strom bereitzustellen.

14. Computerprogramm, das **dadurch gekennzeichnet ist, dass** es eine Codeeinrichtung aufweist, die derart ausgebildet ist, dass, wenn dieselbe durch einen Computer ausgeführt wird, diese die Berechnungen aus den Schritten A.2, A.3 und A.4 des Verfahrens gemäß einem der Ansprüche 1 bis 9 ausführt.

15. Speicherunterstützung, die **dadurch gekennzeichnet ist, dass** dieselbe das Programm gemäß Anspruch 14 auf sich selbst gespeichert hat.

## Revendications

1. Procédé pour la caractérisation de paramètres électriques du circuit équivalent d'un accumulateur en fonction de son état de charge, l'accumulateur comprenant deux bornes, comprenant une étape A.1 d'identification du modèle électrique équivalent de l'accumulateur, une étape A.2 de caractérisation des réactions chimiques primaires de l'accumulateur, c'est-à-dire des réactions qui produisent une accumulation de charge aux bornes de l'accumulateur, une étape A.3 de caractérisation des réactions chimiques secondaires de l'accumulateur, c'est-à-dire des réactions qui ne produisent pas d'accumulation de charge aux bornes de l'accumulateur, et une étape A.4 de calcul des paramètres électriques,
**caractérisé en ce que** lesdites étapes sont comme suit :

A.1) définissant un circuit électrique équivalent **caractérisé par** un ensemble de paramètres électriques, un tel circuit comprenant au moins une branche primaire comprenant des éléments qui, pendant un procédé de chargement, sont traversés par un courant même en présence des seuls réactions chimiques primaires de l'accumulateur et auxquels des paramètres primaires respectifs $P_i$ sont associés, i étant un nombre entier positif, et au moins une branche secondaire comprenant des éléments qui, pendant un procédé de chargement, sont traversés uniquement en présence de réactions chimiques secondaires de l'accumulateur et auxquels des paramètres secondaires respectifs sont associés ;

A.2) caractérisant les paramètres primaires $P_i$ de la branche primaire en effectuant de manière répétitive, pendant une étape initiale d'au moins un procédé de chargement d'un accumulateur dans lequel les réactions secondaires sont négligeables, lorsque l'état de charge de l'accumulateur s'avère être incrémenté d'une quantité prédéterminée obtenue par une mesure de l'état de charge pendant le procédé de chargement entier de l'accumulateur, les sous-étapes suivantes :

A.2.1) appliquer à l'accumulateur une forme d'onde prédéterminée de courant et/ou de tension ;

A.2.2) mesurer pendant un intervalle de temps un nombre prédéterminé de valeurs de tension aux bornes de l'accumulateur et/ou des valeurs de courant entrant dans l'accumulateur ;

A.2.3) interpoler les valeurs de tension et/ou de courant mesurées à l'étape A.2.2, déterminer une fonction d'interpolation qui reconstruit le comportement dans le temps de la tension ou du courant sur l'accumulateur comme une conséquence de l'application de ladite forme d'onde, et obtenir par cette fonction les valeurs des paramètres électriques de ladite au moins une branche primaire ;

obtenir ainsi un ensemble de valeurs pour chaque paramètre primaire $P_i$ et effectuer ensuite la sous-étape suivante :

A.2.4) déterminer pour chaque paramètre primaire $P_i$ de ladite au moins une branche primaire, par interpolation de cet ensemble de valeurs, une fonction faisant le lien entre la valeur du paramètre et l'incrémentation générique de l'état de charge pendant le procédé de chargement, lorsque les seules réactions primaires sont actives ;

A.3) caractériser les paramètres de ladite au moins une branche secondaire en effectuant de manière répétitive, pendant des moments de temps suivant l'étape initiale d'au moins un procédé de chargement d'un accumulateur, les étapes successives suivantes :

A.3.1) une étape de test pour tester la présence de réactions secondaires, où à un moment donné, on mesure la tension et le courant aux bornes de l'accumulateur et on détermine la présence de réactions secondaires si les valeurs de tension et de courant s'écartent par une quantité prédéterminée des valeurs de tension et de courant calculées à l'aide du circuit équivalent comme défini à l'étape A.1, supposant que le courant absorbé dans ladite au moins une branche secondaire disparaît, et déterminer les paramètres de ladite au moins une branche primaire en extrapolant les fonctions déterminées à l'étape A.2.4, et on enregistre : premier moment $t_g$ lors duquel la présence d'une réaction secondaire est déterminée, courant $I_B(t_g)$ mesuré aux bornes de l'accumulateur au moment $t_g$ et l'incrémentation de l'état de charge $\Delta SOC(t_g)$ obtenue depuis le début du procédé de chargement jusqu'au moment $t_g$ comme il ressort des mesures de l'état de charge de l'étape A.2 ;

A.3.2) une étape d'échantillonnage où l'on enregistre un nombre prédéterminé de valeurs de tension et de courant aux bornes de l'accumulateur en fonction de moments après le moment $t_g$ ;

A.4) déterminer à tout moment après la fin de l'étape A.3, des fonctions mathématiques permettant de calculer, pour un procédé de chargement hypothétique, les paramètres électriques primaires $P_i$ de l'accumulateur correspondant à toute valeur de l'état de charge aussi bien en absence qu'en présence de réactions secondaires, effectuer les sous-étapes suivantes :

A.4.1) déterminer sur la base d'une valeur de l'état initial de charge SOCo dudit au moins un procédé de chargement et des valeurs de $t_g$, $I_B(t_g)$ et $\Delta SOC(t_g)$ enregistrées à l'étape A.3.1, une fonction $I_{acc}(SOC)$ reliant le courant maximal $I_{acc}$ qui peut être absorbé par ladite au moins une branche primaire, et l'état de charge SOC, qui vérifie :

$$I_{acc}\left[SOC_0 + \Delta SOC(t_g)\right] = I_B(t_g) \, ,$$

A.4.2) déterminer sur la base de la fonction $I_{acc}$(SOC) et le circuit équivalent de l'accumulateur, les valeurs de tension et de courant aux bornes de ladite au moins un branche secondaire correspondant aux valeurs de tension et de courant aux bornes de l'accumulateur enregistrées à l'étape A.3.2 et, en interpolant de telles valeurs, déterminer une fonction $V_g(I_g)$ qui exprime la relation entre la tension $V_g$ et le courant $I_g$ aux bornes de ladite au moins une branche secondaire ;

A.4.3) déterminer des fonctions mathématiques reliant des paramètres primaires $P_i$ à l'état de charge aussi bien en absence qu'en présence de réactions secondaires, effectuant pour chaque paramètre primaire $P_i$ les sous-étapes suivantes :

A.4.3.1) déterminer par interpolation des valeurs dudit ensemble de valeurs de l'étape A.2, une fonction d'interpolation $f_{pi}$(SOC) qui exprime la relation entre le paramètre $P_i$ et l'état de charge, lorsque les seules réactions primaires sont actives, et

A.4.3.2) déterminer une fonction $f_{si}$(SOC) qui exprime la relation entre le paramètre primaire $P_i$ et l'état de charge, lorsque les réactions secondaires sont également actives, une telle fonction coïncidant avec $f_{pi}$(SOC) si la valeur du paramètre primaire $P_i$ comme fonction de SOC n'est pas influencée par la présence de réactions secondaires, si non sont déterminées par une analyse de circuit sur la base du circuit électrique équivalent de l'accumulateur comme défini à l'étape A.1, la fonction $I_{acc}$(SOC), la fonction $V_g(I_g)$ et les paramètres dont la fonction $f_{si}$(SOC) coïncide avec $f_{pi}$(SOC).

2. Procédé selon la revendication 1, **caractérisé en ce que** l'état de charge initial $SOC_0$ n'est pas connu avant ledit au moins un procédé de chargement, et à la place de l'étape A.4.1, l'étape suivante est mise en oeuvre :

A.4.1a) déterminer l'état de charge initial SOCo dudit au moins un procédé de chargement et une fonction mathématique $I_{acc}$(SOC) reliant le courant maximal $I_{acc}$ qui peut être absorbé par ladite au moins une branche primaire, et l'état de charge SOC, effectuer le procédé itératif qui consiste en les étapes suivantes :

A.4.1.1) supposer une valeur de SOCo ;

A.4.1.2) sur la base de la valeur assumée de SOCo et des valeurs de de $t_g$, $I_B(t_g)$ et $\Delta SOC(t_g)$ enregistrées à l'étape A.3.1, calculer une fonction $I_{acc}$(SOC) qui vérifie la condition :

$$I_{acc} \left[ SOC_0 + \Delta SOC(t_g) \right] = I_B(t_g) ;$$

A.4.1.3) calculer l'incrément de l'état de charge $\Delta SOC_S$ obtenu par intégration du courant $I_{acc}$ calculé selon la fonction déterminée à l'étape A.4.1.2 à partir du moment $t_g$ jusqu'à un moment prédéterminé dudit au moins un procédé de chargement des étapes A.2 et A.3, et calculer l'état de charge $SOC_f$ du procédé de chargement à ce moment prédéterminé, estimé sur la base de la relation suivante :

$$SOC_f = SOC_0 + \Delta SOC(t_g) + \Delta SOC_S ;$$

A.4.1.4) calculer la différence entre l'état de charge réellement atteint au moment prédéterminé dudit au moins un procédé de chargement et l'état de charge $SOC_f$ estimé à l'étape A.4.1.3 ;

A.4.1.5) si la différence calculée à l'étape A.4.1.4 dépasse une quantité prédéterminée, augmenter la valeur supposée de $SOC_0$ d'une quantité qui est fonction de ladite différence, notamment proportionnellement à ladite différence, et répéter les étapes A.4.1.2 à A.4.1.5, si non arrêter le procédé itératif.

3. Procédé selon la revendication 1 ou 2, **caractérisé en ce que**, pour un nombre prédéterminé de répétitions de l'étape A.2.2, un premier groupe de mesures est effectué dans lequel :

- la durée de l'intervalle de temps dans lequel chaque mesure est effectuée, est telle que les mesures de tous les paramètres de ladite au moins une branche primaire puissent être effectuées, et **en ce que** les valeurs mesurées des paramètres sont également utilisées pour définir des fonctions mathématiques exprimant un sous-ensemble des paramètres de ladite au moins une branche primaire comme une fonction d'un autre sous-ensemble des paramètres de ladite au moins une branche primaire considéré comme un ensemble de paramètres de référence ;

et **en ce que** les répétitions restantes de l'étape A.2.2 comprennent un deuxième groupe de mesures dans lequel :

- la durée de l'intervalle de temps est telle que seulement les mesures des paramètres de référence sont possibles et **en ce que** les valeurs des paramètres restants de ladite au moins une branche primaire sont obtenues à partir des valeurs des paramètres de référence par extrapolation, utilisant les fonctions calculées pendant le premier groupe de mesures.

**4.** Procédé selon l'une des revendications 1 à 3, **caractérisé en ce que** la fonction $I_{acc}(SOC)$ est :

$$I_{acc} = \frac{A_0}{1- SOC_i} \left(\frac{1}{SOC} - 1\right)$$

où $SOC_i$ est l'état initial de charge du procédé de chargement hypothétique et $A_0$ est un coefficient constant à valeur réelle, déterminé à l'étape A.4.1 selon la revendication 1 ou à l'étape A.4.1a dans le procédé selon la revendication 2.

**5.** Procédé selon l'une des revendications 1 à 4, **caractérisé en ce que** la fonction $V_g(I_g)$ déterminée à l'étape A.4.2 est :

$$V_g = V_{g0} + a_1 \frac{I_{Bref}}{I_B} I_g + a_2 \left(\frac{I_{Bref}}{I_B}\right)^2 I_g^2 \, ,$$

pendant les intervalles de temps du procédé pendant lesquels le procédé de chargement est à courant constant, c'est-à-dire pendant lesquels le système de chargement connecté à l'accumulateur se comporte comme un générateur de courant, $I_{Bref}$ étant une valeur générique du courant passant par les bornes de l'accumulateur qui est prise comme une valeur de référence $V_{g0}$, et $a_1$ et $a_2$ étant des coefficients constants à valeur réelle déterminés par interpolation d'au moins trois valeurs de $I_g$ et $V_g$ obtenues à l'étape A.4.2,
et à la place, la fonction $V_g(I_g)$ est du type

$$V_g = \frac{I_g - q_g}{M_g}$$

pendant les intervalles de temps du procédé pendant lesquels le procédé de chargement est à tension constante, c'est-à-dire pendant lesquels le système de chargement connecté à l'accumulateur se comporte comme un générateur de tension, $q_g$ et $m_g$ étant deux coefficients à valeur réelle dont la valeur prend en compte la tension appliquée à l'accumulateur pendant l'intervalle de temps particulier pendant lequel le procédé de chargement est à tension constante.

**6.** Procédé selon l'une des revendications 1 à 5, **caractérisé en ce que** ladite au moins une branche primaire du circuit équivalent de l'accumulateur défini à l'étape A.1 comprend un nombre déterminé de résistances et au moins un générateur de tension dont la valeur $V_{oc}$ est un modèle de la tension de circuit ouvert de l'accumulateur.

**7.** Procédé selon la revendication 6, **caractérisé en ce que**, pour chaque résistance appartenant à ladite au moins une branche primaire du circuit équivalent de l'accumulateur, la fonction $f_{pi}(SOC)$ déterminé à l'étape A.4.3.1 est :

$$f_{pi} = \alpha_{mRi0} (SOC - SOC_i) + R_{i0} \, ,$$

où $SOC_i$ est l'état initial de charge du procédé de chargement hypothétique, $m_{Ri0}$ et $R_{i0}$ étant des coefficients constants à valeur réelle déterminés par interpolation d'au moins deux valeurs de ladite résistance comme mesurées à l'étape A.2, et $\alpha$ étant un coefficient dont la valeur est déterminée chaque fois pour chaque procédé de chargement selon la relation

$$\alpha = \frac{1}{m_{Ri0}} \; \frac{f_{si}\,(SOC(t_g)) - R_{i0}}{SOC(t_g) - SOC_i} \; ,$$

où $t_g$ est le moment auquel les réactions secondaires commencent, déterminé comme le moment auquel le courant $I_{acc}$ est égal au courant $I_B$ passant par les bornes de l'accumulateur, $SOC(t_g)$ est la valeur de l'état de charge calculé à $t_g$ et $f_{si}(SOC(t_g))$ est la valeur de la fonction $f_{si}(SOC)$ comme déterminée à l'étape A.4.3.2 calculée de façon correspondante à la valeur de $SOC(t_g)$.

8. Procédé selon l'une des revendications 6 et 7, **caractérisé en ce que** la fonction $f_{pi}(SOC)$ comme déterminée à l'étape A.4.3.1 et la fonction $f_{si}(SOC)$ comme déterminée à l'étape A.4.3.2 pour le générateur de tension de valeur $V_{oc}$ coïncident et sont du type :

$$f_{pi}(SOC) = f_{si}(SOC) = m_v SOC + q_v \; ,$$

où $m_v$ et $q_v$ sont des coefficients constants à valeur réelle déterminés par interpolation d'au moins deux valeurs de $V_{oc}$ déterminées à l'étape A.2.

9. Procédé selon l'une des revendications 1 à 8, **caractérisé en ce que** les étapes A.2 et A.3 sont mises en oeuvre par rapport à un nombre donné de température de travail T de l'accumulateur afin de caractériser les paramètres du circuit équivalent de l'accumulateur même comme une fonction de la température de travail, déterminant à l'étape A.4, par interpolation des valeurs mesurées :

   - une fonction $I_{acc}(SOC, T)$ exprimant la relation entre le courant maximal qui peut être absorbé par ladite au moins une branche primaire et toute paire de valeurs (SOC, T) et une fonction $V_g(I_g, T)$ exprimant la relation entre la tension aux bornes de ladite au moins une branche et toute paire de valeurs ($I_g$, T),

   et, pour chaque paramètre de ladite au moins une branche primaire, déterminant :

   - une fonction $f_{pi}(SOC, T)$ à chaque moment différent en fonction du paramètre $P_i$ qui exprime la relation entre le paramètre et toute paire de valeur (SOC, T) lorsque les seules réactions primaires sont actives, et une fonction $f_{si}(SOC, T)$ chaque fois différente en fonction du paramètre $P_i$ exprimant la relation entre le paramètre et toute paire de valeur (SOC, T) lorsque les réactions secondaires sont également actives, une telle fonction $f_{si}(SOC, T)$ coïncidant avec $f_{pi}(SOC, T)$, si la valeur du paramètre en fonction de (SOC, T) n'est pas influencée par la présence de réactions secondaires, si non étant déterminée par une analyse du circuit équivalent de l'accumulateur, des fonctions $I_{acc}(SOC, T)$, $V_g(I_g, T)$ et des paramètres dont la fonction $f_{si}(SOC, T)$ coïncide avec $f_{pi}(SOC, T)$.

10. Système de chargement pour des accumulateurs d'énergie électrique, un tel système étant pourvu d'une partie d'entrée et d'une partie de sortie et étant adapté pour prendre de l'énergie d'une source par la partie d'entrée et de donner de l'énergie à l'accumulateur par la partie de sortie, le système comprenant les éléments suivants :

   - une partie de puissance adaptée pour fournir à l'accumulateur de l'énergie électrique et pour appliquer à ce même accumulateur des formes d'onde prédéterminées de tension et/ou de courant,
   - un dispositif de mesure de tension pour mesurer la tension aux bornes de l'accumulateur,
   - un dispositif de mesure de courant pour mesurer le courant entrant dans les bornes de l'accumulateur,
   - un dispositif de mémoire et
   - un dispositif électronique de calcul,

   le système étant adapté pour effectuer tout procédé de chargement de l'accumulateur et le procédé de caractérisation de paramètres électriques du circuit électrique équivalent selon l'une des revendications 1 à 9, **caractérisé en ce que** :

   - la partie de puissance est configurée pour appliquer à l'accumulateur une forme d'onde de courant et/ou de tension selon l'étape A.2.1 ;

- le dispositif de mesure de tension et le dispositif de mesure de courant sont configurés pour effectuer les mesures selon les étapes A.2.2, A.3.1, A.3.2 ;
- le dispositif de calcul effectue les calculs selon les étapes A.2, A.3 et A.4 ;
- le dispositif de mémoire est utilisé pour stocker les données calculées selon le procédé.

**11.** Système de contrôle de charge pour un accumulateur d'énergie électrique recevant de l'énergie d'un chargeur externe de batterie, qui comporte une partie d'entrée et une partie de sortie et est adapté pour prendre de l'énergie d'une source par la partie d'entrée et de donner de l'énergie à l'accumulateur par la partie de sortie ayant deux bornes, le système de contrôle de charge étant **caractérisé en ce qu'**il comprend deux bornes de contrôle adaptées pour être connectées directement ou à l'aide d'un ou de davantage de dispositifs en série, aux deux bornes de ladite partie de sortie du chargeur de batterie et **en ce qu'**il comprend en outre :

- un dispositif de chargement adapté pour absorber du courant électrique par les deux bornes de commande ;
- un dispositif de mesure de tension pour mesurer la tension aux bornes de l'accumulateur ;
- un dispositif de mesure de courant pour mesurer le courant entrant dans les bornes de l'accumulateur,
- un dispositif de mémoire et
- un dispositif de calcul,

le système étant adapté pour mettre en oeuvre le procédé de caractérisation de paramètres électriques du circuit électrique équivalent de l'accumulateur selon l'une des revendications 1 à 9, **caractérisé en ce que** :

- le dispositif de chargement est configuré pour absorber du courant électrique par les deux bornes de commande pendant des intervalles de temps prédéterminés d'une façon telle qu'une forme d'onde prédéterminée de courant et/ou de tension soit appliquée à l'accumulateur, selon l'étape A.2.1 ;
- le dispositif de mesure de tension et le dispositif de mesure de courant sont configurés pour effectuer les mesures selon les étapes A.2.2, A.3.1, A.3.2 ;
- le dispositif de calcul effectue les calculs selon l'étape A.2, A.3 et A.4 ;
- le dispositif de mémoire est configuré pour stocker les données calculer dans le procédé.

**12.** Système de contrôle de charge selon la revendication 11, comprenant en outre au moins un bloc de commutation relié en série entre les bornes de la partie de sortie du chargeur de batterie et les bornes de l'accumulateur, un tel bloc de commutation étant configuré de façon à séparer l'accumulateur électriquement de la partie de sortie du chargeur de batterie pendant les intervalles de temps pendant lesquels le dispositif de chargement absorbe du courant, et de connecter l'accumulateur électriquement à la partie de sortie du chargeur de batterie pendant les autres intervalles de temps, le système comprenant en outre les éléments suivants :

- un générateur de tension pourvu de deux bornes adaptées pour être connectées, directement ou à l'aide d'un ou de davantage de dispositifs en série, aux bornes de la partie de sortie du chargeur de batterie, le générateur de tension étant adapté pour établir une différence de tension entre ses bornes ;
- au moins un bloc de commutation connecté en série entre les bornes du générateur de tension et les bornes de la partie de sortie du chargeur de batterie, un tel bloc de commutation étant configuré de façon à connecter le générateur de tension électriquement à la partie de sortie du chargeur de batterie pendant les intervalles de temps pendant lesquels le dispositif de chargement absorbe du courant, et de déconnecter le générateur de tension électriquement de la partie de sortie du chargeur de batterie pendant les autres intervalles de temps.

**13.** Système de contrôle de charge selon l'une des revendications 11 à 12, **caractérisé en ce qu'**il comprend en outre une partie de puissance adaptée pour fournir du courant par les deux bornes de contrôle.

**14.** Programme d'ordinateur, **caractérisé en ce qu'**il comprend de moyens de code configurés de façon telle que, lorsqu'ils sont mis en oeuvre par un ordinateur, ils effectuent les calculs selon les étapes A.2, A.3 et A.4 du procédé selon l'une des revendications 1 à 9.

**15.** Support de mémoire, **caractérisé en ce qu'**il a stocké sur lui-même le programme selon la revendication 14.

Fig. 1

Fig. 2

Fig. 3

Fig. 4

Fig. 5

Fig. 6

Fig. 7

**EP 2 746 797 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4001036 A, Berman
- US 4952861 A, Horn
- US 6246216 B, Satake
- US 0060160479 B, Notten
- US 20110309838 A, Lin
- EP 2375487 A
- US 7095211 B
- US 20110077879 A
- US 6198254 B, Satake
- US 6300763 B, Kwok

**Non-patent literature cited in the description**

- **CERAOLO.** New Dynamical Models of Lead-Acid Batteries. *IEEE Transactions on Power Systems,* 2000, vol. 15 (4